(19) Europäisches Patentamt / European Patent Office / Office européen des brevets

(11) **EP 3 705 773 B1**

(12) **EUROPEAN PATENT SPECIFICATION**

(45) Date of publication and mention
of the grant of the patent:
**30.03.2022 Bulletin 2022/13**

(21) Application number: **20160844.5**

(22) Date of filing: **04.03.2020**

(51) International Patent Classification (IPC):
***F21K 9/61*** *(2016.01)*     ***F21V 8/00*** *(2006.01)*
***G02F 1/13357*** *(2006.01)*

(52) Cooperative Patent Classification (CPC):
**G02F 1/133611; G02F 1/133603; G02F 1/133605;**
G02B 6/002; G02B 6/0021; G02B 6/0073;
G02F 1/133607; G02F 1/133612

(54) **LIGHT EMITTING MODULE**

LICHTEMITTIERENDES MODUL

MODULE ÉMETTEUR DE LUMIÈRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **05.03.2019 JP 2019039973**
              **26.04.2019 JP 2019084913**

(43) Date of publication of application:
**09.09.2020 Bulletin 2020/37**

(73) Proprietor: **NICHIA CORPORATION
Tokushima 774-8601 (JP)**

(72) Inventors:
• **YAMASHITA, Ryohei**
  **Anan-shi, Tokushima 774-8601 (JP)**
• **KATSUMATA, Toshinobu**
  **Anan-shi, Tokushima 774-8601 (JP)**
• **AKAGAWA, Seitaro**
  **Anan-shi, Tokushima 774-8601 (JP)**
• **MORIWAKI, Toshiaki**
  **Anan-shi, Tokushima 774-8601 (JP)**

(74) Representative: **Betten & Resch
Patent- und Rechtsanwälte PartGmbB
Maximiliansplatz 14
80333 München (DE)**

(56) References cited:
**EP-A2- 2 472 309**     **JP-A- 2007 329 114**
**JP-B2- 3 688 832**     **KR-A- 20100 057 321**
**TW-A- 201 116 900**     **US-A1- 2004 042 194**
**US-A1- 2007 121 340**     **US-A1- 2010 220 484**
**US-A1- 2012 069 575**

**Description**

**BACKGROUND**

The present disclosure relates to a light emitting module.

A backlight device consisting of a plurality of backlight units each including a lightguide plate is described in, for example, Japanese Patent Publication No. 2009-150940. The lightguide plate of each backlight unit has a recess at the center of a surface opposite to the emission surface, in which a LED is placed. The plurality of backlight units are arranged such that the emission surfaces of the light guide plates are coplanar and, as a whole, constitute a backlight device. According to the technique disclosed in Japanese Patent Publication No. 2009-150940, an optical sheet which includes a plurality of lens portions is provided on the emission surface side of the lightguide plate of each backlight unit, and a light-reflecting layer which has a plurality of openings is interposed between the lens portions and the light guide plate such that the evenness of light is improved. Japanese Patent Publication No. 2009-150940 also discloses that the lens portions are enlarged as the distance from the LED increases.

Japanese Patent Publication No. 2009-063684 discloses an optical unit which includes a plurality of optical elements on the upper surface side of a plurality of LEDs arranged on a substrate. In this optical unit, each of the plurality of LEDs is located inside a hole formed in a surface of a corresponding optical element which is opposite to the emission surface. In the optical unit of Japanese Patent Publication No. 2009-063684, a recess is formed in the emission surface of each optical element immediately above a LED. Also, a lens array is formed so as to surround the central portion of the emission surface at which the recess is formed. Japanese Patent Publication No. 2009-063684 discloses that a light-diffusing portion, a reflecting portion, or a light shielding portion may be provided inside the recess.

JP 3 688832 B2 discloses a 1st side face extended to a transparent member having a prescribed length in the lengthwise direction is formed to be a light emission face and a light incidence part is formed to a middle part of the 2nd side face in the lengthwise direction opposed to the light emission face in the broadwise direction, a recessed part in nearly V-shape having two slopes is formed to a part of the 1st side face opposed to the light incident part and a bottom area of each slope of the recessed part is formed to be a non-transparent face.

KR 2010 0057321 A discloses a multi chip LED package to simultaneously perform a function of a light guide plate and a diffusing function by a diffusing plate. In detail, a diffusing plate offers an inserting space into which an LED chip is inserted. The diffusing plate diffuses light emitted from the LED chip to perform surface-emission. A conical reflecting member is located in the upper side of the LED chip. The conical reflecting member reflects upper side light of the LED chip. The first reflecting layer reflects light which is incident on the boundary surface of the diffusing plate and a PCB (Printed Circuit Board) substrate.

US 2012/069575 A1 discloses a light converting structure, a light accommodating structure, and a lighting device. The light converting structure includes a bottom conical recess to accommodate a light source, and a top conical recess to distribute the lights emitted from the light source. The light accommodating structure includes a through hole with a small opening and a large opening. A light source is accommodated in the through hole at the large opening, and the lights emitted from the light source output at the small opening.

TW 201116 900 A discloses a light emitting device Including a plurality of light sources, an optical plate, a plurality of recess structures and at least one light guiding structure. The optical plate is disposed on the light sources and has an upper surface and a lower surface. The recess structures cave into the optical plate from the upper surface and each of the recess structures is correspondingly located on a light source wherein a side surface of each of the recess structures has at least two tilting angles. The light guiding structure is disposed on at least one of the upper surface and the lower surface of the optical plate. The light emitted from the light sources under the recess structures is totally internally reflected by the side surfaces of the recess structures and is continuously totally internally reflected at least once in the optical plate until reflected by the light guiding structure then is emitted from the optical plate.

US 2004/042194 A1 discloses a panel light source device comprising light sources, a light guide, and a reflector. The light guide defines a bottom surface and a top surface, and comprises grooves disposed on the bottom surface for receiving the light sources and pairs of first inclined surfaces disposed on the top surface and corresponding to the groove. The grooves and the first inclined surfaces cooperate with each other to transmit the light from the light source into the light guide. The reflector is disposed on the bottom surface of the light guide and covers the light source.

JP 2007 329114 A discloses that a solid light emitting element is disposed at a prescribed position on the first face side of a light guide plate body, and a recessed part is formed in the prescribed region of a second face. The recessed part is formed so as to remove a region in which the optical path of the component of light emitted to the outside of the light guide plate body through the second face, out of light advancing toward the second face side In the inside of the light guide plate body by being emitted from the solid light emitting element, is positioned. The side wall face exposed on the side wall of the recessed part is used as a face for totally reflecting light emitted from the solid light emitting element.

US 2007/121340 A1 discloses a light guide plate. The light guide plate includes a light source hole part configured to accommodate a light source, the light source hole part provided at a back surface on the opposite side of a light emitting surface; and a recessed part provided on the side of said light emitting surface opposed to the light source hole part. The recessed part has, at the bottom portion of the recessed part, a slant surface inclined against the light emitting surface.

## SUMMARY

Reducing the thickness of the light emitting module which includes a plurality of light sources, such as LED, while suppressing the luminance unevenness is beneficial. As the thickness of the light emitting module is reduced, for example, the size of a device which includes a light emitting module as a backlight can be further reduced.

A light emitting module according to the invention includes: a lightguide plate having an upper surface and a lower surface that is opposite to the upper surface, the upper surface including a first hole; a light emitting element provided on a lower surface side of the lightguide plate, the light emitting element opposing the first hole; and a reflective resin layer, wherein the first hole includes a first portion and a second portion, the first portion includes a first lateral surface sloping with respect to the upper surface, the second portion has a second lateral surface sloping with respect to the upper surface, the second lateral surface being present between an opening in the upper surface and the first lateral surface of the first portion, and the reflective resin layer is located in the first portion of the first hole wherein an inclination of the first lateral surface with respect to the upper surface is smaller than an inclination of the second lateral surface with respect to the upper surface.

According to at least any of embodiments of the present disclosure, a light emitting module is provided which achieves improved light uniformity although its thickness is small.

## BRIEF DESCRIPTION OF THE DRAWINGS

FIG. **1** is a schematic perspective view showing an example of configuration of a surface-emission light source of an embodiment of the present disclosure.

FIG. **2** schematically shows a schematic cross section of an example of a light emitting module shown in FIG. **1** and an example of external appearance of the light emitting module as viewed from the upper surface side of a lightguide plate.

FIG. **3** is a schematic enlarged view showing part of FIG. **2** including a light emitting element and its vicinity.

FIG. **4** is a schematic enlarged view when the vicinity of the first hole is viewed in the normal direction of the upper surface of the lightguide plate, showing another example of the shape of a reflective resin layer.

FIG. **5** is a schematic enlarged view when the vicinity of the first hole is viewed in the normal direction of the upper surface of the lightguide plate, showing still another example of the shape of the reflective resin layer.

FIG. **6** is a schematic plan view showing another example of the external appearance when the light emitting module is viewed in the normal direction of the upper surface of the lightguide plate.

FIG. **7** is a schematic cross-sectional view showing a state where the surface-emission light source shown in FIG. **1** is connected with a wiring board.

FIG. **8** is a diagram showing an example of a wiring pattern of an interconnect layer disposed on the surface-emission light source side.

FIG. **9** is a schematic plan view showing an example where a plurality of units of the surface-emission light source shown in FIG. **1** are two-dimensionally arrayed.

FIG. **10** is a schematic plan view showing a configuration where a plurality of sets of the surface-emission light sources shown in FIG. **9** are arrayed in two rows and two columns.

FIG. **11** is a schematic cross-sectional view showing a light emitting module of another embodiment of the present disclosure.

FIG. **12** is a diagram showing a light emitting module of still another embodiment of the present disclosure.

FIG. **13** is a diagram showing a light emitting module of still another embodiment of the present disclosure.

FIG. **14** is a schematic cross-sectional view showing a light emitting module of still another embodiment of the present disclosure.

FIG. **15** is a schematic cross-sectional view showing a light emitting module of still another embodiment of the present disclosure.

FIG. **16** is a schematic plan view showing an exemplary external appearance when the light emitting module shown in FIG. **15** is viewed in the normal direction of the upper surface of the lightguide plate.

FIG. **17** is a schematic plan view showing another example of a lightguide plate which has a plurality of protrusions at its upper surface.

FIG. **18** is a schematic plan view showing still another example of a lightguide plate which has a plurality of protrusions at its upper surface.

FIG. **19** is a diagram showing the external appearance of a sample of Example where a diffuser sheet and the first and second prism sheets were placed on the upper surface side of the lightguide plate, which was viewed from the upper surface side of the lightguide plate with the light emitting elements being lit up.

FIG. **20** is a diagram showing the external appearance of a sample of Comparative Example where a diffuser sheet and the first and second prism sheets were placed on the upper surface side of the lightguide plate, which was viewed from the upper surface side of the lightguide plate with the light emitting elements being lit up.

## DETAILED DESCRIPTION

Embodiments of the present disclosure will now be described in detail with reference to the drawings. The following embodiments are illustrative, and the light emitting module of the present disclosure is not limited thereto. For example, the numerical values, shapes, materials, steps, and the order of steps, etc., to be shown in the following embodiments are merely examples, and various modifications can be made thereto so long as they do not lead to technical contradictions. The embodiments described below are merely illustrative, and various combinations are possible so long as they do not lead to technical contradictions.

The size, the shape, etc., of the components shown in the figures may be exaggerated for ease of understanding, and they may not represent the size and the shape of the components, the size relationship therebetween in an actual light emitting module. Illustration of some components may be omitted in order to prevent the figures from becoming excessively complicated.

In the following description, components of like functions may be denoted by like reference signs and may not be described redundantly. Terms indicating specific directions and positions (e.g., "upper", "lower", "right", "left", and other terms including such terms) may be used in the description below. These terms are used merely for the ease of understanding relative directions or positions in the figure being referred to. The arrangement of components in figures from documents other than the present disclosure, actual products, actual manufacturing apparatuses, etc., may not be equal to that shown in the figure being referred to, as long as it conforms with the directional or positional relationship as indicated by terms such as "upper" and "lower" in the figure being referred to. In the present disclosure, the term "parallel" encompasses cases where two straight lines, sides, planes, etc., are in the range of about 0+5°, unless otherwise specified. In the present disclosure, the term "perpendicular" or "orthogonal" encompasses cases where two straight lines, sides, planes, etc., are in the range of about 90±5°, unless otherwise specified.

EMBODIMENT OF SURFACE-EMISSION LIGHT SOURCE

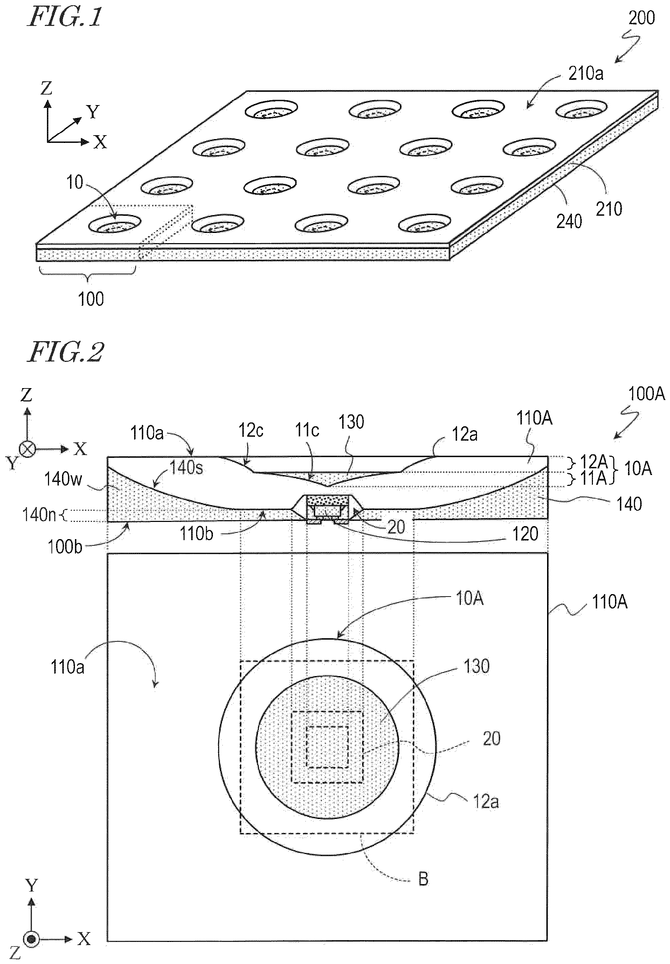

FIG. 1 shows an example of configuration of a surface-emitting light source according to one embodiment of the present disclosure. The surface-emission light source **200** shown in FIG. **1** includes a lightguide plate **210** which has an upper surface **210a** and a light-reflective member **240** in the shape of a layer located under the lightguide plate **210**. Note that FIG. **1** also shows arrows in the x direction, the y direction and the Z direction, which are orthogonal to each other, for the purpose of illustration. Arrows indicating these directions may be also shown in other figures of the present disclosure.

The surface-emitting light source **200** has a plate shape as an entirety. The upper surface **210a** of the lightguide plate **210** forms an emission surface of the surface-emitting light source **200,** and typically has a rectangular shape. Herein, the x direction and the y direction described above respectively coincide with one and the other of mutually orthogonal sides of the rectangular shape of the lightguide plate **210**. The length of one side of the rectangular shape of the lightguide plate **210** is in the range of, for example, not less than 1 to 200 cm. In one embodiment of the present disclosure, one side of the rectangular shape of the upper surface **210a** of the lightguide plate **210** has a length of not less than 20 mm and not more than 25 mm. The longitudinal length and the transverse length of the rectangular shape of the upper surface **210a** can be, for example, about 24.3 mm and about 21.5 mm, respectively.

In the configuration illustrated in FIG. **1,** the surface-emission light source **200** is a collective body of a plurality of light emitting modules **100** each of which includes at least one light emitting element. As schematically shown in FIG. **1,** in this example, the surface-emission light source **200** includes 16 light emitting modules **100** in total which are two-dimensionally arrayed. Herein, the 16 light emitting modules **100** are arrayed in 4 rows and 4 columns. The number of light emitting modules **100** included in the surface-emission light source **200** and the arrangement of the light emitting modules **100** are arbitrary and not limited to the configuration shown in FIG. **1.**

As shown in FIG. **1,** each of the light emitting modules **100** includes a first hole **10** which includes, in its part, an opening at the upper surface **210a** of the lightguide plate **210**. As will be described later, the surface-emission light source **200** can include an optical sheet, such as diffuser sheet, prism sheet, or the like, which is located on the upper surface **210a** side of the lightguide plate **210** so as to cover the first holes **10**. The number of diffuser sheets located on the upper surface **210a** side of the lightguide plate **210** may be one or may be two or more. Likewise, the number of prism sheets located on the upper surface **210a** side of the lightguide plate **210** may be one or may be two or more.

As will be described later in detail, the light emitting element of each of the light emitting modules **100** is located at a position generally immediately under the first hole **10**. In this example, corresponding to the array of the light emitting modules **100** in 4 rows and 4 columns, the light emitting elements are arrayed in 4 rows and 4 columns along the X direction and the Y direction. The arrangement pitch of the light emitting elements can be, for example, in a range of about 0.05 to 20 mm, and may be in the range of about 1 to 10 mm. Herein, the arrangement pitch of the light emitting elements refers to the distance between the optical axes of the light emitting elements. The light emitting elements may be arranged at regular intervals or may be arranged at irregular intervals. The arrangement pitch of the light emitting elements may be equal, or may be different, between two different directions.

FIG. **2** shows a light emitting module **100A** which is an example of the light emitting module **100**. In FIG. **2**, a cross section of the light emitting module **100A** taken along a plane perpendicular to the upper surface **210a** of the lightguide plate **210** in the vicinity of the center of the light emitting module **100A** and an exemplary external appearance of the light emitting module **100A** as viewed from the upper surface **210a** side of the lightguide plate **210** in a direction perpendicular to the upper surface **210a** are schematically shown together in a single drawing.

The light emitting module **100A** includes a lightguide plate **110A**, a light emitting element **120** and a reflective resin layer **130**. The lightguide plate **110A** has an upper surface **110a** that includes a first hole **10A** and a lower surface **110b** that is opposite to the upper surface **110a**. The reflective resin layer **130** is provided inside the first hole **10A**. The lightguide plate **110A** may be a part of the lightguide plate **210** shown in FIG. **1**. The first hole **10A** of the lightguide plate **110A** may be one of the plurality of first holes **10** shown in FIG. **1**. Note that the lightguide plate **110A** may be in the form of a single lightguide plate which is continuous between two adjoining light emitting modules **100A** in the surface-emission light source **200**. Note that, however, for example, when each light emitting module **100A** includes an independent lightguide plate **110A**, a definite border may be found between the lightguide plates **110A** of two light emitting modules **100A** in the surface-emission light source **200**.

In the configuration illustrated in FIG. **2**, the light emitting module **100A** may further include a light-reflective member **140** which is located on the lower surface **110b** side of the lightguide plate **110A**. The light-reflective member **140** is a part of the light-reflective member **240** shown in FIG. **1**. In this example, the light-reflective member **140** includes a basal portion **140n** which is in the shape of a layer and a wall portion **140w** rising from the lower surface **110b** side of the lightguide plate **110A** to the upper surface **110a** side of the lightguide plate **110A**. The wall portion **140w** has a slope surface **140s** which surrounds the light emitting element **120**. In the lower part of FIG. **2**, the rectangle **B**, which is the outermost one of the broken line rectangles, represents the position of the inner periphery of the wall portion **140w**. In the example described herein, the inner periphery of the wall portion **140w** is rectangular, although the inner periphery of the wall portion **140w** may have any other shape, such as circular, elliptical, etc. As is the lightguide plate **110A**, the light-reflective member **140** can be continuous so as to extend across two adjoining light emitting modules **100A** in the surface-emission light source **200**.

The first hole **10A** of the lightguide plate **110A** is provided in the vicinity of the center of the upper surface **110a**. Herein, the first hole **10A** includes a first portion **11A** which has a first lateral surface **11c** sloping with respect to the upper surface **110a** and a second portion **12A** which has a second lateral surface **12c** sloping with respect to the upper surface **110a**. As shown in the drawing, the second lateral surface **12c** of the second portion **12A** may be part of one or more lateral surfaces which define the shape of the first hole **10A** which is present between an opening **12a** located at the upper surface **110a** of the lightguide plate **110A** and the first lateral surface 11c of the first portion **11A**. The degree of the inclination of the first lateral surface **11c** with respect to the upper surface **110a** is different from the degree of the inclination of the second lateral surface **12c** with respect to the upper surface **110a**. In this example, the first portion **11A** of the first hole **10A** generally has the shape of an inverted cone, and the second portion **12A** of the first hole **10A** has the shape of an inverted truncated cone.

In the light emitting module **100A**, the light emitting element **120** is located on the lower surface **110b** side of the lightguide plate **110A** so as to oppose the first hole **10A** provided in the upper surface **110a** of the lightguide plate **110A**. In the example shown in FIG. **2**, a second hole **20** is provided at the lower surface **110b** side of the lightguide plate **110A**, and the light emitting element **120** is located inside this second hole **20** in a plan view. The optical axis of the light emitting element **120** is generally coincident with the center of the first hole **10A**.

As previously described, the reflective resin layer **130** of each light emitting module **100A** is located inside the first hole **10A**. In the present embodiment, the reflective resin layer **130** is in the first portion **11A** that is part of the first hole **10A** which is closer to the light emitting element **120**. In this example, the reflective resin layer **130** is arranged so as to occupy the entirety of the first portion **11A** inside the first hole **10A**.

As will be described later, the reflective resin layer **130** may contain or be made of a light-reflective material. The first hole **10A** is provided at a position in the lightguide plate **110A** which opposes the light emitting element **120** and, therefore, light emitted from the light emitting element **120** can be reflected at a position on the lateral surface which defines the shape of the first hole **10A**. According to the invention, the first hole **10A**, which includes the first portion **11A** that has the first lateral surface **11c** and the second portion **12A** that has the second lateral surface **12c,** is provided on the upper surface **110a** side of the lightguide plate **110A** and, therefore, the first lateral surface **11c** and the second lateral surface 12c, which have inclinations of different degrees with respect to the upper surface **110a,** are used as a reflection surface such that light from the light emitting element **120** can be more efficiently diffused throughout the plane of the lightguide plate **110A.** Further, since the reflective resin layer **130** is arranged so as to oppose the light emitting element **120,** the luminance in a region of the upper surface **110a** of the lightguide plate **110A** immediately above the light emitting element **120** can be prevented from being excessively higher than in the other regions. Herein, since the reflective resin layer **130** is selectively provided inside the first portion **11A** of the first hole **10A,** excessive decrease of the luminance in the region immediately above the light emitting element **120** can be avoided. As a result, light of improved uniformity can be realized while the overall thickness of the light emitting module **100A** is reduced.

Hereinafter, the constituents of the light emitting module **100A** will be described in more detail.


LIGHTGUIDE PLATE **110A**

The lightguide plate **110A** has the function of diffusing light from the light emitting element **120** and emitting it from the upper surface **110a.** In the present embodiment, an aggregate of the upper surfaces **110a** of the plurality of lightguide plates **110A** constitute the light emitting surface of the surface-emission light source **200.**

The lightguide plate **110A** is a generally plate-shaped light-transmitting member that may be formed of at least one of a thermoplastic resin such as acrylic, polycarbonate, cyclic polyolefin, polyethylene terephthalate and polyester, a thermosetting resin such as epoxy and silicone, glass, and combinations thereof. Particularly, polycarbonate, among others, can realize a high transparency while being inexpensive. Note that the terms "light-transmitting" and "light transmission" as used herein are understood to encompass diffusiveness for incident light, and not limited to being "transparent". The lightguide plate **110A** may have a light diffusion function by including a material dispersed therein that has a different refractive index than that of the base material, for example.

The first hole **10A** provided in the upper surface **110a** of the lightguide plate **110A** has the function of reflecting light emitted from the light emitting element **120** and then introduced from the lower surface **110b** side of the lightguide plate **110A** such that the reflected light diffuses throughout the plane of the lightguide plate **110A.** By providing the first hole **10A** as such a light-diffusing structure in the lightguide plate **110A,** the luminance can be improved at the upper surface **110a** exclusive of the region immediately above the light emitting element **120.** That is, the luminance unevenness across the upper surface of the light emitting module **100A** can be suppressed, and the first hole **10A** as the light-diffusing structure contributes to reduction in thickness of the lightguide plate **110A.** The thickness of the lightguide plate **110A,** i.e., the distance from the lower surface **110b** to the upper surface **110a,** is typically in a range of about 0.1 to 5 mm. According to certain embodiments of the present disclosure, the thickness of the lightguide plate **110A** can be within the range of not more than about 750 $\mu$m.

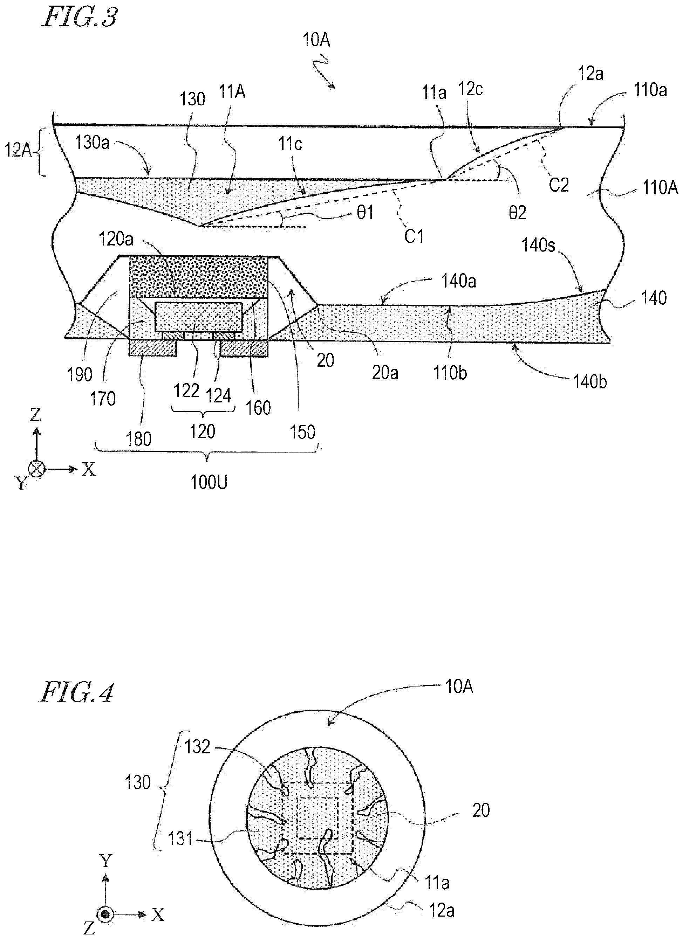

FIG. **3** enlargedly shows part of FIG. **2** including the light emitting element **120** and its vicinity. In the present embodiment, the first hole **10A** includes the first portion **11A** that has the first lateral surface **11c** and the second portion **12A** that has the second lateral surface **12c.** As previously described, the reflective resin layer **130** is located inside the first portion **11A.** In the example shown in FIG. **2** and FIG. **3,** the entirety of the first portion **11A** is filled with the reflective resin layer **130.** For example, when the entirety of the first portion **11A** is filled with the reflective resin layer **130** and the entirety of the first lateral surface **11c** is covered with the reflective resin layer **130,** light introduced into the lightguide plate **110A** and traveling to the first hole **10A** can be effectively reflected at the first lateral surface

As shown in FIG. **3,** and according to the invention, the inclination of the first lateral surface **11c** with respect to the upper surface **110a** of the lightguide plate **110A** is smaller than the inclination of the second lateral surface **12c.** Due to such a shape of the first hole **10A,** the area of the first lateral surface **11c** can be increased while increase in depth of the first hole **10A** is suppressed. Therefore, light incident on the first lateral surface **11c** can be more effectively diffused throughout the plane of the lightguide plate **110A** while increase in thickness of the lightguide plate **110A** is avoided. On the contrary, the inclination of the second lateral surface **12c** with respect to the upper surface **110a** of the lightguide plate **110A** may be smaller than the inclination of the first lateral surface **11c.** Due to such a configuration, the capacity of the second portion **12A** can be increased while increase in thickness of the lightguide plate **110A** is avoided. For example, the air layer in the first hole **10A** can be enlarged to a broader area. Accordingly, a greater amount of light is incident on the second lateral surface **12c,** and the light can be more effectively diffused throughout the plane of the lightguide plate **110A.**

In the configuration illustrated in FIG. **3,** the cross-sectional shape of the first lateral surface **11c** of the first portion **11A** of the first hole **10A** and the cross-sectional shape of the second lateral surface **12c** of the second portion **12A** are both curved. In this case, the degree of the inclination of the first lateral surface **11c** and the second lateral surface 12c can be defined as follows.

The degree of the inclination of the first lateral surface **11c** can be defined by the angle formed by a line extending between the lower end and the upper end of the first lateral surface **11c** and a line parallel to the upper surface **110a** of the lightguide plate **110A** in a cross-sectional view. Likewise, the degree of the inclination of the second lateral surface **12c** can also be defined by the angle formed by a line extending between the lower end and the upper end of the second lateral surface **12c** and a line parallel to the upper surface **110a** of the lightguide plate **110A** in a cross-sectional view. Note that, however, in this example, the cross-sectional shape of the first lateral surface **11c** and the cross-sectional shape of the second lateral surface **12c** are both curved. In such a case, the degree of the inclination can be determined as follows.

Herein, the first portion **11A** of the first hole **10A** generally has the shape of an inverted cone. Therefore, the first portion **11A** has an opening **11a** inside the first hole **10A,** and the opening **11a** corresponds to the periphery of the base of the inverted cone shape of the first portion **11A**. Herein, the angle θ1 formed by a line **C1** in FIG. **3** and a line parallel to the upper surface **110a** of the lightguide plate **110A** represents the degree of the inclination of the first lateral surface **11c**. The line **C1** is a line extending between a part of the first portion **11A** at which the distance from the lower surface **110b** of the lightguide plate **110A** is smallest (in this example, the apex of the inverted cone) and the opening **11a**. Likewise, the angle θ'2 formed by the line **C2** in FIG. **3** extending between the opening **11a** of the first portion **11A** and the opening **12a** of the second portion **12A** and a line parallel to the upper surface **110a** of the lightguide plate **110A** represents the degree of the inclination of the second lateral surface **12c.**

Herein, the cross-sectional shape of the first lateral surface **11c** and the second lateral surface **12c** is curved. However, the cross-sectional shape of the first lateral surface **11c** and the second lateral surface **12c** is not limited to a curved shape but may be a bent and/or stepped shape or a linear shape. The cross-sectional shape of the first lateral surface **11c** and the cross-sectional shape of the second lateral surface **12c** do not need to be identical with each other. If the cross-sectional shape of the first lateral surface **11c** and/or the second lateral surface **12c** is a curved shape such as illustrated in FIG. **3,** particularly a curve which is convex toward the inside of the first hole **10A**, light is likely to diffuse to positions away from the center of the lightguide plate **110A**. This is advantageous from the viewpoint of achieving uniform light on the upper surface **110a** side.

In this example, the inside of the second portion **12A** of the first hole **10A** is not filled with a resin or the like, i.e., is the air layer. In other words, the inside of the second portion **12A** has a lower refractive index than the first portion **11A**. Therefore, in this example, the second lateral surface **12c** of the second portion **12A** is the interface between the air layer and the lightguide plate **110A** and functions as a reflection surface such that light introduced into the lightguide plate **110A** and traveling toward the first hole **10A** is brought back into the lightguide plate **110A**. That is, the second lateral surface **12c** of the second portion **12A** enables light which is incident on the upper surface **110a** of the lightguide plate **110A** at a near-vertical angle to diffuse into the lightguide plate **110A**. The second portion **12A** may be filled with a material which has a lower refractive index than the material of the reflective resin layer **130.**

The specific shape of the first hole **10A** is not limited to the shape illustrated in FIG. **3**. The specific configuration of the first hole **10A** as the light-diffusing structure can be appropriately determined according to the shape and characteristics of the light emitting element located on the lower surface **110b** side of the lightguide plate **110A.** The shape of the first portion **11A** and the second portion **12A** of the first hole **10A** may be the shape of, for example, a cone, a polygonal pyramid such as quadrangular pyramid, hexagonal pyramid, etc., or a truncated polygonal pyramid. The depth of the first hole **10A** is in the range of, for example, not less than 300 μm and not more than 400 μm. The depth of the first portion **11A** can be in the range of, for example, not less than 100 μm and not more than 200 μm. The diameter of the opening **11a** of the first portion **11A** can be, for example, about 2 mm. The diameter of the opening **12a** of the second portion **12A** can be, for example, about 3 mm.

The lightguide plate **110A** may be a single layer, or may have a layered structure including a plurality of light-transmitting layers. When a plurality of light-transmitting layers are layered together, a layer having a different refractive index, e.g., an air layer, or the like, may be provided between any layers. With the provision of an air layer, for example, between any layers of the layered structure, it may be easier to diffuse light from the light emitting element **120** and it allows to further reduce the unevenness in luminance.

In the illustrated example, the lightguide plate **110A** has the second hole **20** on the lower surface **110b** side at a position opposite to the first hole **10A**. Inside the second hole **20,** a bonding member **190** and a light emitter **100U** that includes the light emitting element **120** are provided. The light emitter **100U** includes a plate-like wavelength conversion member **150,** a bonding member **160** and a second light-reflective member **170** in addition to the light emitting element **120.** The light emitter **100U** is bonded at the position of the second hole **20** of the lightguide plate **110A** by the bonding member **190.**

As seen from FIG. **2,** the second hole **20** has the shape of, for example, a truncated quadrangular pyramid. Typically, the center of the second hole **20** that is located on the lower surface **110b** side of the lightguide plate **110A** is approximately coincident with the center of the first hole **10A** that is located on the upper surface **110a** side. A dimension of an opening **20a** of the second hole **20** which is formed at the lower surface **110b** of the lightguide plate **110A** along a diagonal direction of the rectangular shape can be, for example, in range of 0.05 to 10 mm, preferably not less than 0.1 mm and not more than 1 mm.

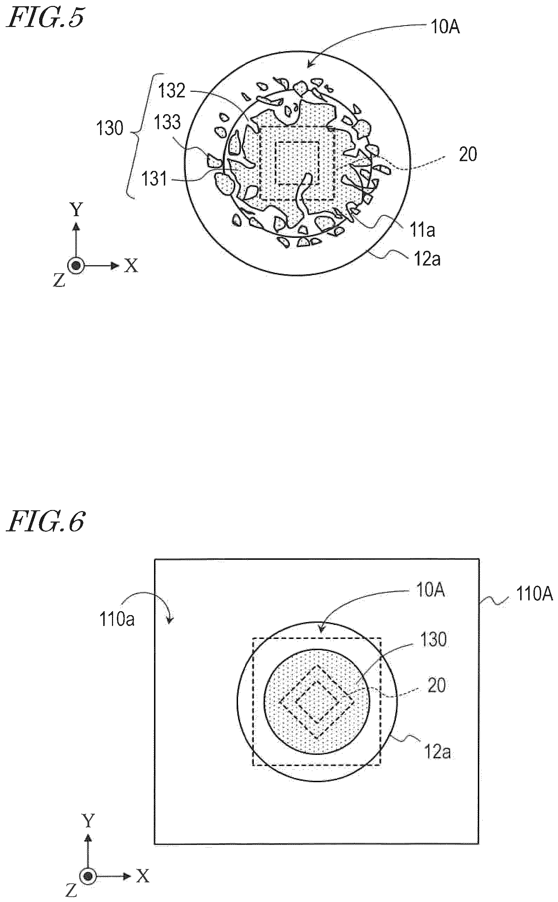

When the planar shape of the second hole **20** is rectangular, the second hole **20** may be formed at the lower surface **110b** of the lightguide plate **110A** such that one side of the rectangular shape of the second hole **20** is parallel to one side of the rectangular shape of the lightguide plate **110A** as shown in FIG. **2.** Alternatively, as shown in FIG. **6,** the second hole **20** may be formed at the lower surface **110b** of the lightguide plate **110A** so as to be inclined with respect to one side of the rectangular shape of the lightguide plate **110A.**

FIG. **6** shows an example where the rectangular shape of the opening **20a** of the second hole **20** is inclined by 45° with respect to the rectangular shape of the lightguide plate **110A.** As illustrated in FIG. **6,** by forming the second hole **20** such that each side of the rectangular shape of the opening **20a** is generally parallel to the diagonal line of the rectangular shape of the lightguide plate **110A,** the four lateral surfaces of the second hole **20** face the corners of the rectangular shape of the lightguide plate **110A.** That is, the distance from the corners of the truncated quadrangular pyramid shape of the second hole **20** to the lateral surfaces of the lightguide plate **110A** can be decreased while the distance from the lateral surfaces of the second hole **20** to the corners of the lightguide plate **110A** is increased. According to the optical characteristics of the light emitter **100U,** such a configuration can more strongly suppress the luminance unevenness.

Examples of the planar shape of the second hole **20** include not only rectangular shapes such as shown in FIG. **2** and FIG. **6** but also circular shapes. It is not indispensable for an embodiment of the present disclosure that the external shape of the second hole **20** is similar to the external shape of the lightguide plate **110A.** The shape and size of the second hole **20** can be appropriately determined according to required optical characteristics. For example, the second hole **20** may have the shape of a truncated cone.

REFLECTIVE RESIN LAYER **130**

Again, refer to FIG. **3.** As previously described, the reflective resin layer **130** is located in the first portion **11A** of the first hole **10A.** It is not indispensable for an embodiment of the present disclosure that the entirety of the first portion **11A** is filled with the reflective resin layer **130.** The reflective resin layer **130** may occupy part of the first portion **11A.** For example, the reflective resin layer **130** may be provided in the first hole **10A** so as to cover the first lateral surface **11c** of the first portion **11A.**

The reflective resin layer **130** is made of a light-reflective material such as, for example, a resin material in which a light-reflective filler is dispersed. In this specification, the terms "reflective" and "light-reflective" refer to a circumstance where the reflectance at the emission peak wavelength of the light emitting element **120** is not less than 60%. The reflectance of the reflective resin layer **130** at the emission peak wavelength of the light emitting element **120** is more beneficially not less than 70%, still more beneficially not less than 80%.

The base material of a resin material used for forming the light-reflective resin layer **130** can be a silicone resin, a phenolic resin, an epoxy resin, a BT resin, a polyphthalamide (PPA), etc. The light-reflective filler used can be metal particles, or particles of an inorganic or organic material which has a higher refractive index than the base material. Examples of the light-reflective filler include particles of titanium dioxide, silicon oxide, zirconium dioxide, potassium titanate, aluminum oxide, aluminum nitride, boron nitride, mullite, niobium oxide, barium sulfate, or particles of various rare earth oxides such as yttrium oxide and gadolinium oxide. It is beneficial that the reflective resin layer **130** is white.

The distribution of the light-reflective filler in the reflective resin layer **130** may be generally uniform throughout the reflective resin layer **130** or may be nonuniform or gradient. For example, if in the step of forming the reflective resin layer **130** the filler precipitates or separates from the base material before the base material is cured, the distribution of the light-reflective filler in the reflective resin layer **130** can be nonuniform. For example, as shown in FIG. **4,** the reflective resin layer **130** can include a first region **131** and second regions **132** in which the density of the filler is relatively low. In the example shown in FIG. **4,** there are a plurality of second regions **132** extending from the periphery to the center of the first hole **10A.** Alternatively, as in the example shown in FIG. **5,** the reflective resin layer **130** can include a plurality of island portions **133** in the vicinity of the opening **11a** of the first portion **11A.**

If the number density of the filler which is defined by the number of the filler per unit area in a plan view is relatively high in the vicinity of the center of the reflective resin layer **130** as compared with the vicinity of the periphery of the reflective resin layer **130,** the luminance in a region immediately above the light emitting element **120** can readily be prevented from being locally excessively high and, therefore, this is beneficial. In each of the examples shown in FIG. **4** and FIG. **5,** the number density of the filler is relatively high in the vicinity of the center of the reflective resin layer **130** as compared with the vicinity of the periphery of the reflective resin layer **130.**

When the reflective resin layer **130** is located above the light emitting element **120,** light emitted from the light emitting element **120** traveling toward the upper surface **110a** of the lightguide plate **110A** in the vicinity of the center of the lightguide plate **110A** can be reflected by the reflective resin layer **130.** Therefore, light emitted from the light emitting element **120** can be efficiently diffused throughout the plane of the lightguide plate **110A.** Also, the luminance in a region of the upper surface **110a** of the lightguide plate **110A** immediately above the light emitting element **120** can be prevented from being locally excessively high. Note that, however, it is not indispensable that the reflective resin layer **130** completely blocks light from the light emitting element **120.** In this sense, the reflective resin layer **130** may have a semi-transmissive property such that the reflective resin layer **130** transmits part of the light from the light emitting element **120.**

Herein, the upper surface **130a** of the reflective resin layer **130** is generally flat. Note that, however, the shape of the upper surface **130a** of the reflective resin layer **130** is not limited to this example but may be convexed toward the side opposite to the light emitting element **120** or concaved toward the light emitting element **120** side. Particularly, when the upper surface **130a** of the reflective resin layer **130** is convexed toward the side opposite to the light emitting element **120,** the thickness in the vicinity of the center of the reflective resin layer **130** relative to the position of the opening **11a** of the first portion **11A** is relatively large. As a result, the luminance in a region immediately above the light emitting element **120** can be more effectively prevented from being locally excessively high.

In the example shown in FIG. **3,** the reflective resin layer **130** fills the space between the deepest part of the first portion **11A** and the position of the opening **11a.** In other words, in this example, the reflective resin layer **130** does not reach a higher level beyond the position of the opening **11a** inside the first hole **10A.** However, it is not indispensable for an embodiment of the present disclosure that the reflective resin layer **130** does not include a portion beyond the position of the opening **11a.** It is tolerable that the reflective resin layer **130** includes a portion which is present inside the second portion **12A** of the first hole **10A.** If the inclination of the first lateral surface **11c** is smaller than the inclination of the second lateral surface **12c,** increase in area of the reflective resin layer **130** in the first hole **10A** in a plan view can readily be suppressed even though part of the reflective resin layer **130** reaches the inside of the second portion **12A.** That is, excessively low luminance in the vicinity of the first hole **10A** can readily be avoided.

LIGHT EMITTING ELEMENT **120**

Typical examples of the light emitting element **120** include an LED. In the configuration illustrated in FIG. **3,** the light emitting element **120** includes a main body **122,** and an electrode **124** located on the side opposite to the upper surface **120a** of the light emitting element **120.** For example, the main body **122** may include a support substrate of sapphire or gallium nitride, etc., and a semiconductor layered structure on the support substrate. The semiconductor layered structure includes an n-type semiconductor layer, a p-type semiconductor layer, and an active layer interposed between these semiconductor layers. The semiconductor layered structure may include a nitride semiconductor ($In_xAl_yGa_{1-x-y}N$, $0{\leq}x$, $0{\leq}y$, $x+y{\leq}1$) capable of emitting light in the ultraviolet to visible range. In this example, the upper surface **120a** of the light emitting element **120** coincides with the upper surface of the main body **122.** The electrode **124** may include a pair of a positive electrode and a negative electrode, and may have the function of supplying a predetermined current to the semiconductor layered structure.

The light emitting elements **120** provided in the surface-emission light source **200** may each be an element that emits blue light or may be an element that emits white light. The light emitting elements **120** may include elements that emit light of different colors from each other. For example, the light emitting elements **120** may include elements that emit red light, elements that emit blue light, and elements that emit green light. Herein, an LED that emits blue light is shown as an example of the light emitting element **120.**

In this example, in each light emitting module **100A,** the light emitting element **120** is secured to the lower surface of the wavelength conversion member **150** by the bonding member **160.** The planar shape of the light emitting element **120** is typically a rectangular shape. One side of the rectangular light emitting element **120** has a length of, for example, 1000 μm or shorter. The light emitting element **120** may have a length of 500 μm or shorter in each of the longitudinal direction and the transverse direction. A light emitting element having a length of 500μm or shorter in each of the longitudinal direction and the transverse direction is easily available at low cost. Alternatively, the light emitting element **120** may have a length of 200μm or shorter in each of the longitudinal direction and the transverse direction. A light emitting element having such short sides is advantageous to represent a high definition video, and/or to perform a local dimming operation or the like when being applied to a backlight unit of a liquid crystal display device. Particularly, a light emitting element having a length of 250μm or shorter both in the longitudinal direction and the transverse direction has a small area size of the upper surface thereof, and therefore, outputs a relatively large amount of light from a side surface thereof. Therefore, it is easy to obtain a batwing light distribution characteristic. Herein, a batwing light distribution characteristic generally refers to a light distribution characteristic that is defined as an emission intensity distribution such that the emission intensity is higher at angles at which the absolute value of the light distribution angle is greater than 0°, where 0° is the optical axis that is perpendicular to the upper surface of the light emitting element.

WAVELENGTH CONVERSION MEMBER **150**

In the configuration illustrated in FIG. **3,** the wavelength conversion member **150** is located inside the second hole **20** between the lightguide plate **110A** and the light emitting element **120.** In other words, the wavelength conversion member **150** is located at a position which is above the light emitting element **120** and which is at the bottom portion of the second hole **20.** Herein, "the bottom portion of the second hole **20"** means a portion of the second hole **20** which is considered as the bottom portion when the lower surface **110b** of the lightguide plate **110A** is oriented upward. In this specification, the terms "bottom portion" and "bottom surface" can also be used without being bound by the orientation of the light emitting module depicted in the figure. When the light emitting module **100A** is in the orientation shown in FIG. **3,** the bottom portion of the second hole **20** can also be said to be a ceiling portion of the dome-shaped structure formed on the lower surface **110b** side of the lightguide plate **110A.**

The wavelength conversion member **150** absorbs at least part of light emitted from the light emitting element **120** and emits light at a wavelength different from the wavelength of the light from the light emitting element **120.** For example, the wavelength conversion member **150** may convert part of blue light from the light emitting element **120** and emit yellow light. With such a configuration, blue light which has passed through the wavelength conversion member **150** and yellow light emitted from the wavelength conversion member **150** are mixed together, resulting in white light. In the configuration illustrated in FIG. **3,** light emitted from the light emitting element **120** is basically guided into the lightguide plate **110A** via the wavelength conversion member **150.** Therefore, the mixed light may be diffused inside the lightguide plate **110A** and, for example, white light with suppressed luminance unevenness may be extracted from the upper surface **110a** of the lightguide plate **110A.** The embodiment of the present disclosure is advantageous in achieving uniform light as compared with a case where light is first diffused in the lightguide plate and then the wavelength thereof is converted.

The wavelength conversion member **150** is, typically, a member in which phosphor particles are dispersed in a resin. Examples of the resin in which the phosphor particles are to be dispersed include silicone resins, modified silicone resins, epoxy resins, modified epoxy resins, urea resins, phenolic resins, acrylic resins, urethane resins, fluoric resins, and a resin containing two or more of these resins. From the viewpoint of efficiently guiding light into the lightguide plate **110A,** it is beneficial that the base material of the wavelength conversion member **150** has a lower refractive index than the material of the lightguide plate **110A.** A material which has a different refractive index from that of the base material may be dispersed in the material of the wavelength conversion member **150** such that the wavelength conversion member **150** can have a light diffusion function. For example, particles of titanium dioxide, silicon oxide, or the like, or combinations thereof may be dispersed in the base material of the wavelength conversion member **150.**

The phosphor may be a known material. Examples of the phosphor include YAG-based phosphors, fluoride-based phosphors such as KSF-based phosphors, nitride-based phosphors such as CASN, and β-SiAlON phosphors, and combinations thereof. The YAG-based phosphors are examples of a wavelength converting substance which is capable of converting blue light to yellow light. The KSF-based phosphors and CASN are examples of a wavelength converting substance which is capable of converting blue light to red light. The β-SiAlON phosphors are examples of a wavelength converting substance which is capable of converting blue light to green light. The phosphor may be a quantum dot phosphor.

It is not indispensable that the phosphor contained in the wavelength conversion member **150** is the same among a plurality of light emitting modules **100** included in the same surface-emission light source **200.** Among the plurality of light emitting modules **100,** the phosphor dispersed in the base material of the wavelength conversion member **150** may differ. In some of a plurality of second holes **20** provided in the lightguide plate **210** of the surface-emission light source **200,** a wavelength conversion member which is capable of converting incident blue light to yellow light may be provided and, in some others of the second holes **20,** a wavelength conversion member which is capable of converting incident blue light to green light may be provided. Further, in the remaining second holes **20,** a wavelength conversion member which is capable of converting incident blue light to red light may be provided.

BONDING MEMBER **160**

The bonding member **160** is a light-transmitting member that covers at least part of a lateral surface of the light emitting element **120.** As schematically shown in FIG. **3,** the bonding member **160** typically includes a layer-shaped portion that is located between the upper surface **120a** of the light emitting element **120** and the wavelength conversion member **150.**

The material of the bonding member **160** can be a resin composition which contains a transparent resin material as the base material. The bonding member **160** has a transmittance of, for example, not less than 60% for light which has the emission peak wavelength of the light emitting element **120.** From the viewpoint of effectively using light, the transmittance of the bonding member **160** at the emission peak wavelength of the light emitting element **120** is beneficially not less than 70%, more beneficially not less than 80%.

Typical examples of the base material of the bonding member **160** include a thermosetting resin such as an epoxy resin or a silicone resin. Examples of the base material of the bonding member **160** include a silicone resin, a modified silicone resin, an epoxy resin, a phenol resin, a polycarbonate resin, an acrylic resin, a polymethylpentene resin or a polynorbornene resin, or a material containing two or more of these resins. The bonding member **160** typically has a lower refractive index than the refractive index of the lightguide plate **110A.** In the bonding member **160,** for example, a material which has a different refractive index from the base material may be dispersed such that the bonding member **160** has a light diffusion function.

As previously described, the bonding member **160** covers at least portion of the lateral surface of the light emitting element **120**. The bonding member **160** has an outer surface which is the interface with the light-reflective member **170** which will be described later. Light emitted from the lateral surface of the light emitting element **120** so as to be incident on the bonding member **160** is reflected at the position of the outer surface of the bonding member **160** toward a region lying above the light emitting element **120**. The cross-sectional shape of the outer surface of the bonding member **160** is not limited to a linear shape such as shown in FIG. **3**. The cross-sectional shape of the outer surface of the bonding member **160** may be a zigzag line, a curve which is convex in a direction toward the light emitting element **120**, or a curve which is convex in a direction away from the light emitting element **120**.

(SECOND) LIGHT-REFLECTIVE MEMBER **170**

The light-reflective member **170** is a member which is located on the lower surface side of the wavelength conversion member **150** (on a side opposite to the lightguide plate **110A**) and which is capable of reflecting light. As shown in FIG. **3**, the light-reflective member **170** covers the outer surface of the bonding member **160**, part of the lateral surface of the light emitting element **120** which is not covered with the bonding member **160**, and the lower surface of the light emitting element **120** which is opposite to the upper surface **120a** exclusive of the electrode **124**. The light-reflective member **170** covers the lateral surface cf the electrode **124**, while the lower surface of the electrode **124** is exposed out of the lower surface of the light-reflective member **170**.

The material of the light-reflective member **170** can be similar to the material of the reflective resin layer **130**. For example, the material of the light-reflective member **170** and the material of the reflective resin layer **130** may be the same. The lower surface of the light emitting element **120**, exclusive of the electrode **124**, is covered with the light-reflective member **170**, whereby leakage of light to the side opposite to the upper surface **110a** of the lightguide plate **110A** can be suppressed. Further, the light-reflective member **170** also covers the lateral surface of the light emitting element **120** so that light from the light emitting element **120** can be converged at a higher place and efficiently guided into the wavelength conversion member **150**.

SECOND BONDING MEMBER **190**

As previously described, the light emitter **100U** is provided at the bottom portion of the second hole **20** by means of the second bonding member **190**. As shown in FIG. **3**, at least part of the second bonding member **190** is located inside the second hole **20**. The second bonding member **190** may include a portion which is present between the bottom portion of the second hole **20** and the wavelength conversion member **150**. As shown in FIG. **3**, the second bonding member **190** can include a portion raised toward the side opposite to the upper surface **110a** of the lightguide plate **110A** beyond the lower surface **110b** of the lightguide plate **110A**.

The second bonding member **190** is made of a resin composition which contains a transparent resin material as the base material as is the bonding member **160**. The material of the second bonding member **190** may be the same as, or may be different from, the material of the bonding member **160**. The second bonding member **190** typically has a lower refractive index than the refractive index of the lightguide plate **110A**.

LIGHT-REFLECTIVE MEMBER **140**

The light-reflective member **140** is capable of reflecting light and covers at least part of the lower surface **110b** of the lightguide plate **110A**. Herein, the light-reflective member **140** may cover not only the lower surface **110b** of the lightguide plate **110A** but also the second bonding member **190**. When the second bonding member **190** is covered with the light-reflective member **140** as in this example, leakage of light from the second bonding member **190** to the lower surface **110b** side of the lightguide plate **110A** is suppressed so that the light extraction efficiency can be improved.

The light-reflective member **140** may include the wall portion **140w** in its part and, as a result, part of the upper surface **140a** of the light-reflective member **140** which is opposite to the lower surface **110b** of the lightguide plate **110A** has the slope surface **140s**. As seen from FIG. **2**, typically, the slope surface **140s** surrounds the light emitting element **120** along the four sides of the rectangular shape of the upper surface **110a** of the lightguide plate **110A**. The slope surface **140s** may function as a reflection surface which is capable of reflecting incident light toward the upper surface **110a** of the lightguide plate **110A**. Therefore, the light-reflective member **140** that has the slope surface **140s** is located on the lower surface **110b** side of the lightguide plate **110A**, whereby light traveling toward the lower surface **110b** side of the lightguide plate **110A** can be reflected by the slope surface **140s** toward the upper surface **110a**, so that light can be efficiently extracted from the upper surface **110a**. Further, the slope surface **140s** is provided in a peripheral portion of the lightguide plate **110A**, so that the luminance in the peripheral portion of the lightguide plate **110A** can be prevented from being relatively low as compared with the central portion.

The cross-sectional shape of the slope surface **140s** may be curved such as shown in FIG. **2** or may be linear.

The cross-sectional shape of the slope surface **140s** is not limited to such examples but may include steps, bends, etc.

The height of the wall portion that surrounds the light emitting element **120** may vary among a plurality of light emitting modules **100** included in a single surface-emission light source **200** or may vary within a single light emitting module **100.** For example, one of a plurality of slope surfaces **140s** included in a single surface-emission light source **200** which is located at the outermost position in the lightguide plate **210** of the surface-emission light source **200** may have a greater height than the slope surfaces **140s** located at the other portions of the lightguide plate **210.**

The material of the light-reflective member **140** may be the same as the material of the above-described second light-reflective member **170.** When the material of the light-reflective member **140** is the same as the material of the light-reflective member **170,** a light-reflective member which covers an approximate entirety of the lower surface **110b** of the lightguide plate **110A** may be integrally formed of a light-reflective material. When the light-reflective member **140** is provided on the lower surface **110b** side of the lightguide plate **110A,** the effect of reinforcing the lightguide plate **110A** may also be achieved.

INTERCONNECT LAYER **180**

In the configuration illustrated in FIG. **3,** the light emitting module **100A** further includes an interconnect layer **180** located on the lower surface **140b** of the light-reflective member **140.** The interconnect layer **180** includes a wiring electrically coupled with the electrode **124** of the light emitting element **120.** In this example, the interconnect layer **180** is depicted as being present on the light-reflective member **170,** although the interconnect layer **180** can include a portion which is present on the lower surface **140b** of the light-reflective member **140.**

The interconnect layer **180** is typically a single-layer or multilayer film which is made of a metal such as Cu. The interconnect layer **180** is connected with an unshown power supply, or the like, and accordingly functions as a terminal for supplying a predetermined electric current to each light emitting element **120.**

The interconnect layer **180** is provided on the lower surface **100b** side of the light emitting module **100A,** whereby for example a plurality of light emitting elements **120** included in the surface-emission light source **200** can be electrically coupled together via the interconnect layer **180.** That is, the light emitting element **120** can be driven by the unit of the surface-emission light source **200,** for example. As will be described later, a plurality of surface-emission light sources **200** can be combined together to form a larger surface-emission light source, and a local dimming operation of this surface-emission light source is possible. When the interconnect layer **180** is provided on the lower surface **100b** side of the light emitting module **100A,** wirings are provided on the surface-emission light source **200** side that includes a plurality of light emitting elements **120** and, therefore, connection with the power supply, or the like, is easy. That is, by connecting the power supply, or the like, surface emission is easily realized. As a matter of course, the light emitting element **120** may be driven by the unit of one or more light emitting modules **100A.**

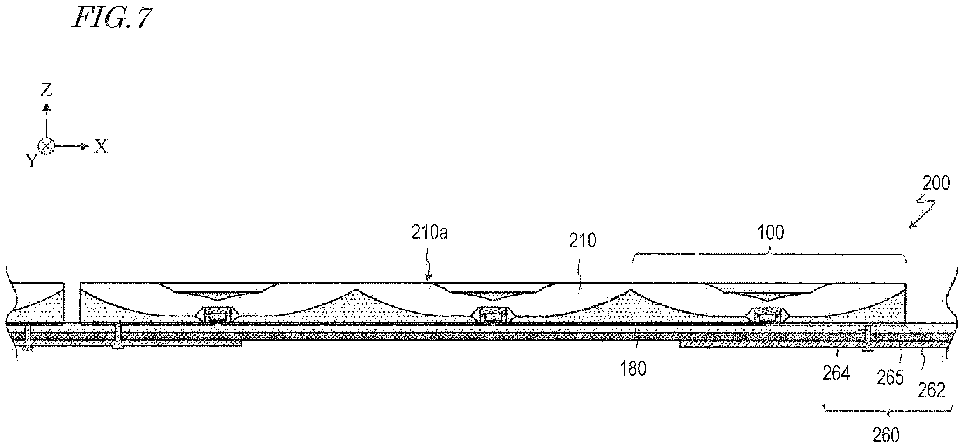

FIG. **7** shows a state where the surface-emission light source **200** is connected with a wiring board. In one embodiment, a light-emitting device of the present disclosure can include a wiring board **260** as shown in FIG. **7.** In the configuration illustrated in FIG. **7,** the wiring board **260** includes an insulating substrate **265,** an interconnect layer **262** provided on the insulating substrate **265,** and a plurality of vias **264.** The interconnect layer **262** is provided on one of the principal surfaces of the insulating substrate **265.** The vias **264** have connection with the interconnect layer **262.** The interconnect layer **262** is electrically coupled with the surface-emission light source **200** by the vias **264** provided inside the insulating substrate **265.**

The wiring board **260** is located on the lower surface side of the surface-emission light source **200,** i.e., on the side opposite to the upper surface **210a** of the lightguide plate **210.** The surface-emission light source **200** is mounted to the wiring board **260** by, for example, soldering the interconnect layer **180** to the vias **264** of the wiring board **260.** According to the present embodiment, the interconnect layer **180** that has connection with each of the light emitting elements **120** can be provided on the surface-emission light source **200** side and, therefore, connections required for local dimming and the like can be easily formed without forming a complicated wiring pattern on the wiring board **260** side. The interconnect layer **180** can have a larger area than the lower surface of the electrode **124** of each light emitting element **120** and, therefore, formation of electrical connections with the interconnect layer **262** is relatively easy. Alternatively, for example, if the light emitting module **100A** does not include the interconnect layer **180,** the electrode **124** of the light emitting element **120** may be connected with the vias **264** of the wiring board **260.**

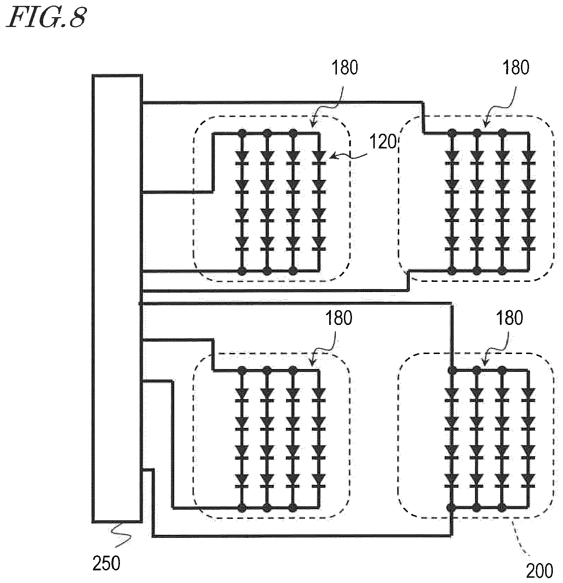

FIG. **8** shows an example of the wiring pattern of the interconnect layer **180.** For the sake of simplicity, FIG. **8** shows an example where four units of the surface-emission light source **200** shown in FIG. **1** are connected with a single driver **250.**

Each surface-emission light source **200** can include the interconnect layer **180.** In each surface-emission light source **200,** the interconnect layer **180** electrically couples together a plurality of light emitting modules **100A** included in the surface-emission light source **200.** In the example shown in FIG. **8,** the interconnect layer **180** included in each surface-emission light source **200** connects four light emitting elements **120** in series and connects four groups of the serially-connected light emitting elements **120** in parallel.

As shown in FIG. **8,** each of these interconnect layers **180** can be connected with the driver **250** that drives the light emitting elements **120.** The driver **250** may be provided on a substrate which supports an aggregate of the surface-emission light sources **200** (e.g., wiring board **260)** and electrically coupled with the interconnect layer **180.** Alternatively, the driver **250** may be provided on another substrate which is separate from the substrate that supports an aggregate of the surface-emission light sources **200** and electrically coupled with the interconnect layer **180.** With such a circuit configuration, a local dimming operation by the unit of the surface-emission light source **200** which includes 16 light emitting elements **120** is possible. As a matter of course, connection of a plurality of light emitting elements **120** via the interconnect layer **180** is not limited to the example shown in FIG. **8.** The light emitting elements **120** may be connected such that each of the light emitting modules **100A** included in the surface-emission light source **200** can be independently driven. Alternatively, the light emitting modules **100A** included in the surface-emission light source **200** may be separated into a plurality of groups, and a plurality of light emitting elements **120** may be electrically coupled such that the light emitting elements **120** are driven by the unit of a group including a plurality of light emitting modules **100A.**

As described hereinabove, according to an embodiment of the present disclosure, light from the light emitting element **120** can be diffused throughout the plane of the lightguide plate **110A** while excessive increase in luminance in a region immediately above the light emitting element **120** is suppressed by reflection at the reflective resin layer **130.** Thereby, it can provide uniform light although it is small in thickness. Further as in the example described with reference to FIG. **3,** the wavelength conversion member **150** is interposed between the light emitting element **120** and the lightguide plate **110A,** so that color-mixed light can be diffused throughout the plane of the lightguide plate **110A** before being emitted from the upper surface **110a** of the lightguide plate **110A.**

According to an embodiment of the present disclosure, for example, the thickness of the structure including the light-reflective member **140,** in other words, the distance from the lower surface of the electrode **124** of the light emitting element **120** to the upper surface **110a** of the lightguide plate **110A,** may be reduced to, for example, 5 mm or smaller, 3 mm or smaller, or 1 mm or smaller. The distance from the lower surface of the electrode **124** of the light emitting element **120** to the upper surface **110a** of the lightguide plate **110A** can be not less than about 0.7 mm and not more than about 1.1 mm.

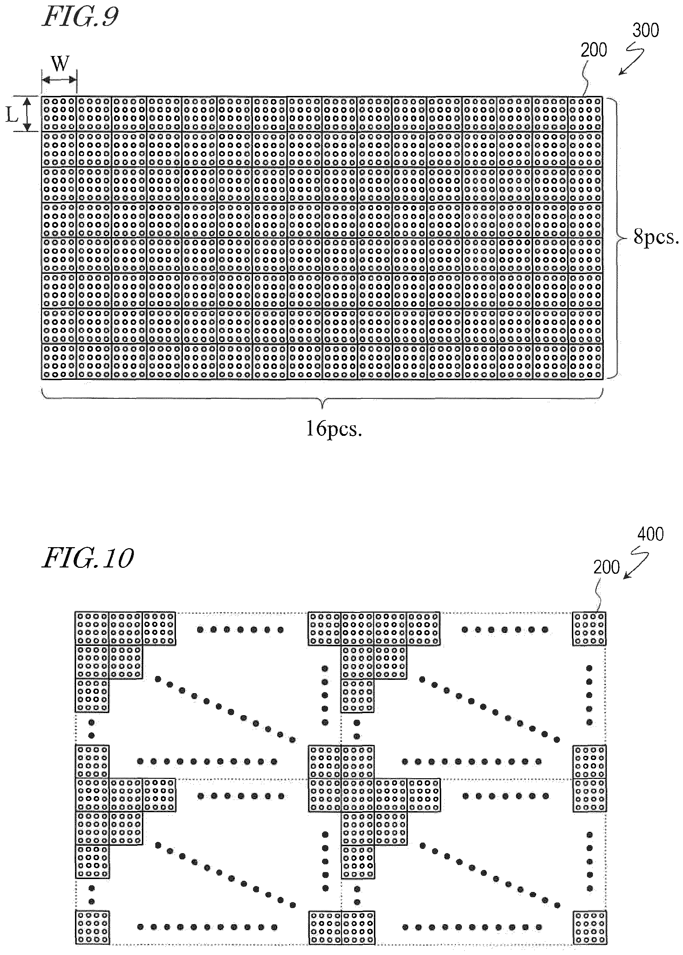

FIG. **9** shows an example where a plurality of surface-emission light sources **200** are two-dimensionally arrayed. By two-dimensionally arraying a plurality of surface-emission light sources **200,** a large-area light emitting surface can be realized.

A surface-emission light source **300** shown in FIG. **9** includes a plurality of sets of the surface-emission light source **200** shown in FIG. **1.** In the example shown in FIG. **9,** the surface-emission light sources **200** are arrayed in 8 rows and 16 columns. FIG. **9** schematically shows the two-dimensional array of the surface-emission light sources **200** as viewed from the upper surface **210a** side of the lightguide plate **210.**

The lightguide plates **210** of two surface-emission light sources **200** which are adjoining each other in the row or column direction are typically in direct contact with each other. However, it is not indispensable that a two-dimensional array is formed such that the lightguide plates **210** of two adjoining surface-emission light sources **200** are in direct contact with each other. A lightguide structure may be interposed between two adjoining lightguide plates **210** such that the lightguide structure optically couples together the two adjoining lightguide plates **210.** Such a lightguide structure can be formed by, for example, applying a light-transmitting adhesive onto the lateral surface of the lightguide plate **210** and then curing the applied adhesive. Alternatively, the lightguide structure may be formed by two-dimensionally arraying a plurality of surface-emission light sources **200** with gaps therebetween, filling the gaps between two adjoining lightguide plates **210** with a light-transmitting resin material, and thereafter curing the resin material. The material of the lightguide structure provided between the lightguide plates **210** can be the same as the material of the previously-described bonding member **160.** As the base material of the lightguide structure, using a material which has a refractive index equal to or higher than the material of the lightguide plate **210** is beneficial. The lightguide structure provided between the lightguide plates **210** may have a light diffusion function.

When the longitudinal length L and the transverse length W of each surface-emission light source **200** are, for example, about 24.3 mm and about 21.5 mm, respectively, the array of surface-emission light sources **200** shown in FIG. **9** is suitable for a 15.6-inch screen size with an aspect ratio of 16:9. For example, the surface-emission light source **300** shown in FIG. **9** can be suitably used for the backlight unit of a laptop computer having a 15.6-inch screen size.

In this example, an aggregate of the upper surfaces **210a** of the lightguide plates **210,** which is the upper surface of each surface-emission light source **200,** forms a light emitting surface. Therefore, by changing the number of surface-emission light sources **200** included in the surface-emission light source **300** or by changing the arrangement of the surface-emission light sources **200,** the surface-emission light source **300** can be readily applied to a plurality of types of liquid crystal panels of different screen sizes. That is, there is no need to redo the optical calculations for the lightguide plate **210** included in the surface-emission light source **200** or to remake a mold for formation of the lightguide plate **210,** and it is possible to flexibly conform to changes in the screen size. Therefore, changing the screen size will not incur an increase in the manufacturing cost and the lead time.

FIG. **10** shows a configuration where a plurality of sets of the surface-emission light sources **200** shown in FIG.

**9** are arrayed in two rows and two columns. In this case, a total of 512 surface-emission light sources **200** together form a surface-emission light source **400** that is compatible with a 31.2-inch screen size with an aspect ratio of 16:9. For example, the array of the surface-emission light sources **200** shown in FIG. **10** can be used as the backlight unit of a liquid crystal television, etc. Thus, according to the present embodiment, it is relatively easy to obtain a large-area light emitting surface.

According to the method of forming a larger light emitting surface by a combination of a plurality of surface-emission light sources **200,** it is possible to flexibly conform to liquid crystal panels of a variety of screen sizes without the necessity of re-designing the optical system or remaking a mold for formation of the lightguide plate in consideration of the screen size. That is, it is possible to produce a backlight unit that is compatible with a certain screen size at a low cost and within a short period of time. Another advantage is that even if there is a light emitting element that cannot be lit due to a breakage of wire, or the like, it is possible to simply replace a surface-emission light source that includes the inoperative light emitting element. Note that in a surface-emission light source which includes a two-dimensional array of a plurality of surface-emission light sources **200** such as illustrated in FIG. **9** and FIG. **10,** one or more diffuser sheets and/or one or more prism sheets may be provided on the upper surface **210a** side of the plurality of lightguide plates **210** so as to cover all of the upper surfaces **210a.**

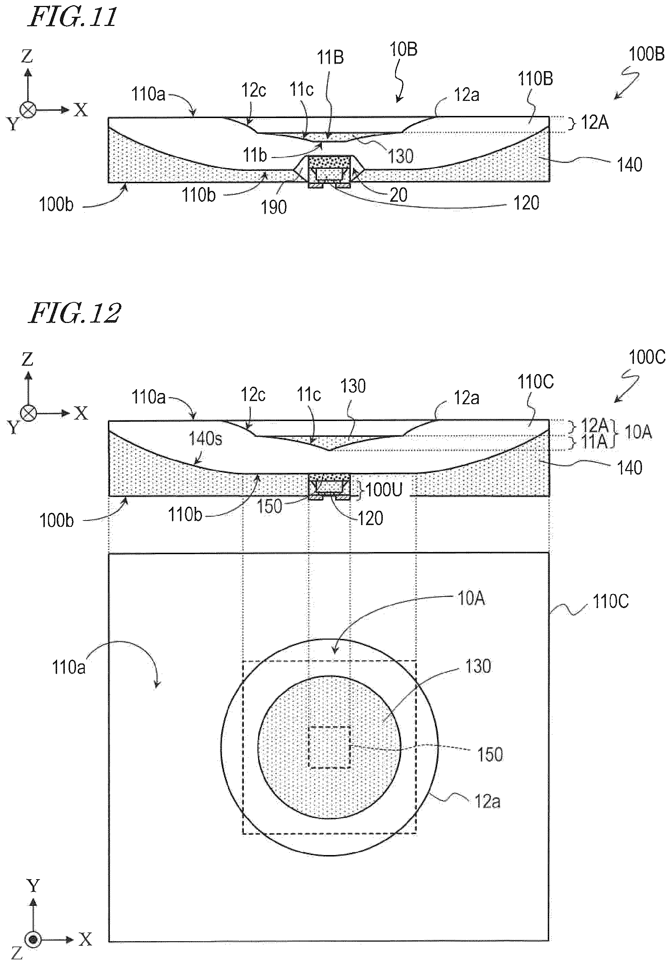

FIG. **11** shows a light emitting module of another embodiment of the present disclosure. The light emitting module **100B** shown in FIG. **11** is different from the light emitting module **100A** which has been described with reference to FIG. **2** in that the light emitting module **100B** includes a lightguide plate **110B** in place of the lightguide plate **110A.**

In the configuration illustrated in FIG. **11,** the upper surface **110a** of the lightguide plate **110B** has a first hole **10B** which opposes the second hole **20** on the lower surface **110b** side. The first hole **10B** includes a first portion **11B** which has a first lateral surface **11c** and a second portion **12A** which has a second lateral surface **12c.** As shown in FIG. **11,** the first portion **11B** further has a bottom surface **11b** connecting to the first lateral surface **11c.** That is, in this example, the first portion **11B** has the shape of an inverted truncated cone which is defined by the first lateral surface **11c** and the bottom surface **11b.** The diameter of the circular shape of the bottom surface **11b** of the first portion **11B** is, for example, about 0.3 mm.

Typically, the bottom surface **11b** of the first portion **11B** is a flat surface which is parallel to the upper surface **110a** of the lightguide plate **110B.** The shape of the first portion **11B** of the first hole **10B** is determined so as to include the bottom surface **11b** and, therefore, the depth of the first hole **10B** can be reduced while the reduction in volume of the reflective resin layer **130** is suppressed. That is, the light emitting module **100B** can have a smaller thickness.

FIG. **12** shows a light emitting module of still another embodiment of the present disclosure. The light emitting module **100C** shown in FIG. **12** includes a lightguide plate **110C.** As shown in the drawing, the lightguide plate **110C** is different from the previously-described lightguide plates **110A** and **110B** in that the second hole **20** is not provided on the lower surface **110b** side of the lightguide plate **110C** and that the light-reflective member **140** covers an approximate entirety of the lower surface **110b** of the lightguide plate **110C.** Note that, as does FIG. **2,** FIG. **12** schematically shows together in a single drawing a cross section of the light emitting module **100C** taken along a plane perpendicular to the upper surface **210a** of the lightguide plate **210** in the vicinity of the center of the light emitting module **100C** and an exemplary external appearance of the light emitting module **100C** as viewed from the upper surface **210a** side of the lightguide plate **210** in a direction perpendicular to the upper surface **210a.**

In an embodiment of the present disclosure, formation of the second hole **20** in the lightguide plate is not indispensable. As illustrated in FIG. **12,** the light emitter **100U** may be bonded onto the lower surface side of the light emitting module **100C,** i.e., herein, onto the lower surface **110b** of the lightguide plate **110C.** The light emitter **100U** may be bonded to the lower surface **110b** of the lightguide plate **110C** using the above-described bonding member 190. Note that, instead of the light emitter **100U,** the light emitting element **120** may be secured onto the lower surface **110b** of the lightguide plate **110C** via the wavelength conversion member **150.**

In the configuration illustrated in FIG. **12,** the wavelength conversion member **150** is interposed between the light emitting element **120** and the lightguide plate **110C.** Herein, the wavelength conversion member **150** has a rectangular shape in a plan view. As shown in the lower part of FIG. **12,** in a plan view, the wavelength conversion member **150** is located in a region more internal than the opening **12a** that defines the periphery of the first hole **10A.** In this example, one side of the rectangular shape of the wavelength conversion member **150** is parallel to one side of the rectangular shape of the lightguide plate **110C,** although the wavelength conversion member **150** may be located on the lower surface **110b** side of the lightguide plate **110C** such that one side of the rectangular shape of the wavelength conversion member **150** is not parallel to one side of the rectangular shape of the lightguide plate **110C.**

When the thicknesses of the wavelength conversion member **150** and the light-reflective member **140** are adjusted such that the entirety of the lateral surfaces of the wavelength conversion member **150** is covered with the light-reflective member **140,** leakage of light from the lower surface **100b** side of the light emitting module **100C** can be suppressed and, therefore, this is advantageous from the viewpoint of the light extraction efficiency. As a matter of course, the first hole **10B** that is shaped as shown in FIG. **11** may be employed in place of the first hole **10A** of the lightguide plate **110C.**

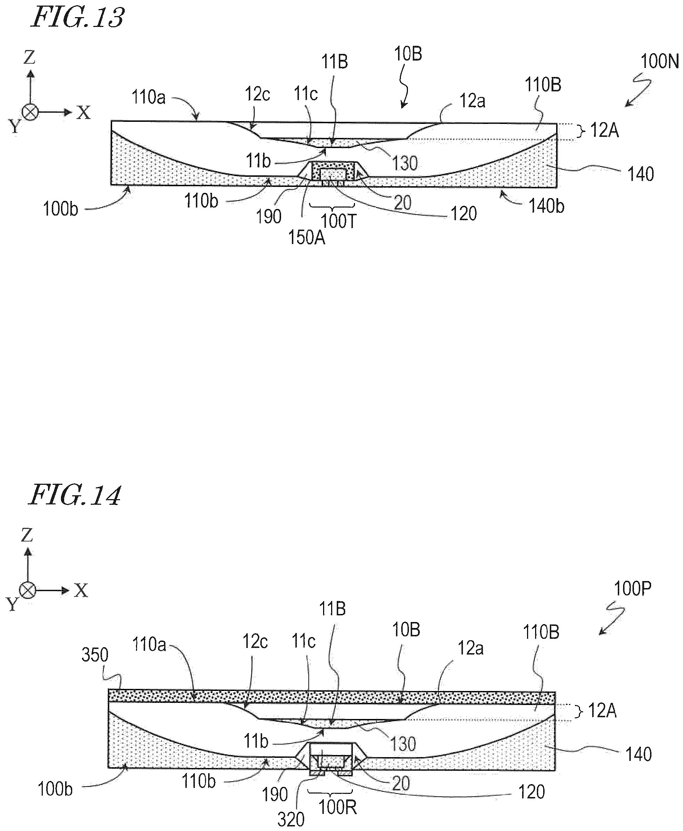

FIG. **13** schematically shows a cross section of a light emitting module of still another embodiment of the present disclosure. The light emitting module **100N** shown in FIG. **13** includes a lightguide plate **110B** and a light emitter **100T.** The light emitter **100T** includes a light emitting element **120** and a wavelength conversion member **150A.** As schematically shown in FIG. **13,** the light emitter **100T** is provided at the bottom portion of the second hole **20** of the lightguide plate **110B** via the bonding member **190.**

In this example, the wavelength conversion member **150A** covers not only the upper surface **120a** of the light emitting element **120** but also the lateral surfaces of the main body **122.** The shape of the wavelength conversion member is not limited to a plate-like shape but may be a shape which covers the lateral surface of the light emitting element **120.** In this example, the light-reflective member **140** also covers parts of the wavelength conversion member **150A** and the light emitting element **120** located on the side opposite to the upper surface **110a** of the lightguide plate **110B.** Note that, however, the lower surface of the electrode **124** of the light emitting element **120** is exposed out of the lower surface **140b** of the light-reflective member **140** on the lower surface **100b** side of the light emitting module **100N.** Such a configuration can suppress leakage from the lower surface **140b** of light traveling from the light emitting element **120** toward the lower surface **100b** side of the light emitting module **100N.**

FIG. **14** schematically shows a cross section of a light emitting module of still another embodiment of the present disclosure. The light emitting module **100P** shown in FIG. **14** includes a lightguide plate **110B,** a light emitter **100R** and a wavelength conversion sheet **350.** In the configuration illustrated in FIG. **14,** the wavelength conversion sheet **350** is located on the upper surface **110a** of the lightguide plate **110B.** The wavelength conversion sheet 350 may be in contact with the upper surface **110a** of the lightguide plate **110B** or may be provided above the lightguide plate **110B** so as to be spaced away from the upper surface **110a** of the lightguide plate **110B.** When optical sheets such as diffuser sheet and prism sheet are provided above the lightguide plate **110B,** it is preferred that the diffuser sheet, the wavelength conversion sheet 350 and the prism sheet are provided above the lightguide plate **110B** in increasing order of distance from the upper surface **110a.** That is, it is preferred that the diffuser sheet is located between the upper surface **110a** of the lightguide plate **110B** and the wavelength conversion sheet **350,** and the wavelength conversion sheet **350** is located between the diffuser sheet and the prism sheet.

The wavelength conversion sheet **350** is, typically, a resin sheet in which phosphor particles are dispersed. When such a wavelength conversion sheet **350** is used, the phosphor can be uniformly provided above the lightguide plate **110B.** The same effect can be achieved also when the lightguide plate **110A** is employed in place of the lightguide plate **110B.** The phosphor can be a known material. Examples of the phosphor include fluoride-based phosphors such as KSF-based phosphors, nitride-based phosphors such as CASN, YAG-based phosphors, and β-SiAlON phosphors. The phosphor may be a quantum dot phosphor.

The light emitter **100R** is different from the above-described light emitter **100U** in that the light emitter **100R** includes a plate-like light-transmitting member **320** instead of the wavelength conversion member **150.** That is, the light emitter **100R** includes a light emitting element **120,** the light-transmitting member **320,** a bonding member **160** and a light-reflective member **170.**

The light-transmitting member **320** is made of a material which is capable of transmitting light. Examples of the material of the light-transmitting member **320** include silicone resins, modified silicone resins, epoxy resins, modified epoxy resins, urea resins, phenolic resins, acrylic resins, urethane resins, fluoric resins, and a resin containing two or more of these resins. A material which has a different refractive index from that of the base material may be dispersed in the material of the light-transmitting member 320 such that the light-transmitting member **320** can have a light diffusion function. For example, particles of titanium dioxide, silicon oxide, or the like, may be dispersed in the base material of the light-transmitting member **320.**

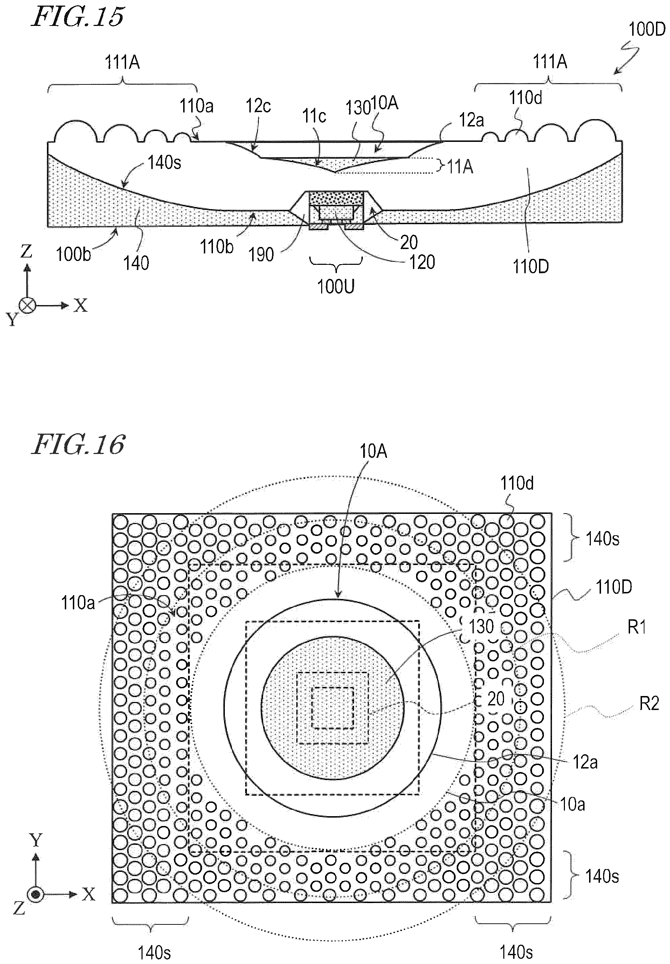

FIG. **15** schematically shows a cross section of a light emitting module of still another embodiment of the present disclosure. The light emitting module **100D** shown in FIG. **15** is also an example of the light emitting module **100** that is a constituent of the above-described surface-emission light source **200.** As shown in the drawing, the light emitting module **100D** includes a lightguide plate **110D,** which has an upper surface **110a** and a lower surface **110b,** and a light emitting element **120** provided on the lower surface **110b** side of the lightguide plate **110D.**

The upper surface **110a** of the lightguide plate **110D** includes, at least in its part, a first region **111A** in which a plurality of protrusions or recesses are provided. The first region **111A** is located in a region of the upper surface **110a** which does not overlap the first hole **10A.** In the example shown in FIG. **15,** a plurality of protrusions **110d** are provided in the first region **111A.**

When, for example, the plurality of protrusions **110d** are provided in a region of the surface on the upper surface **110a** side of the lightguide plate **110D** which does not overlap the first hole **10A,** light from the light emitting element **120** which is introduced into the lightguide plate **110D** from the lower surface **110b** side of the lightguide plate **110D** can be efficiently extracted from the first region **111A.** That is, the luminance in the first region **111A** as viewed in the normal direction of the upper surface **110a** of the lightguide plate **110D** can be relatively improved.

FIG. **16** schematically shows an exemplary external appearance when the light emitting module **100D** shown in FIG. **15** is viewed in the normal direction of the upper surface **110a** of the lightguide plate **110D.** In this example, the first region **111A** occupies the entirety of a region of the upper surface **110a** which does not overlap the first hole **10A**, and the plurality of protrusions **110d** are provided in the form of a plurality of dots in the first region **111A**. Note that FIG. **15** and FIG. **16** are merely schematic diagrams for illustrating the configuration of the upper surface **110a** of the lightguide plate **110D,** and the number or shape of the plurality of protrusions **110d** or other components may not be strictly identical between the cross-sectional view and the plan view. The same applies to the other drawings of the present disclosure.

As schematically shown in FIG. **16,** the proportion of the protrusions **110d** per unit area in the first region **111A** increases concentrically in an outward direction from the light emitting element **120**. In this example, each of the plurality of protrusions **110d** has a circular external shape in a plan view, and the diameter of the circular shape of the protrusions **110d** increases as the distance from the center of the lightguide plate **110D** increases. More specifically, protrusions **110d** located in a region between an imaginary circle **R1** and an imaginary circle **R2** around the position of the light emitting element **120,** which are represented by dotted lines in FIG. **16** (the circle **R2** is greater than the circle **R1**), have a greater diameter than protrusions **110d** located in a region between the circle **R1** and the opening **10a** of the first hole **10A**. Further, some of the plurality of protrusions **110d** which are located outside the circle **R2** have a greater diameter than the protrusions **110d** located in a region between the circle **R1** and the circle **R2**. As understood from the configuration shown in FIG. **16**, it is not indispensable that the diameter of the plurality of protrusions **110d** evenly increases as the distance from the light emitting element **120** increases.

According to the configuration such as illustrated in FIG. **16** where the proportion of the plurality of protrusions **110d** per unit area in the first region **111A** increases concentrically in an outward direction from the light emitting element **120,** the light emitted from a position away from the light emitting element **120** can be relatively increased. In this example, a plurality of protrusions **110d** provided near the four corners of the upper surface **110a** of the lightguide plate **110D** have the largest diameter among the protrusions **110d** provided in the first region **111A**. Therefore, as compared with the other regions of the first region **111A,** the luminance near the four corners of the upper surface **110a** of the lightguide plate **110D** can be relatively increased. Since the luminance in a region which is likely to be relatively dark is improved, the luminance unevenness can be suppressed more effectively while increase in thickness of the lightguide plate **110D** is suppressed.

In the configuration illustrated in FIG. 16, each of the plurality of protrusions **110d** is a circular dot. The diameter of the circular shape is in the range of, for example, not less than 1 $\mu$m and not more than 500 $\mu$m. As a matter of course, the planar shape of each protrusion **110d** is not limited to a perfect circle. The planar shape of each of the plurality of protrusions **110d** may be an elliptical shape, a deformed circular shape, a polygonal shape, or an indeterminate shape. In this specification, the planar shape of the protrusion or recess refers to the shape of the periphery of a protrusion or recess projected onto a plane parallel to the upper surface of the lightguide plate. When the planar shape of a protrusion (or recess) is not circular, the diameter of an imaginary circle which includes the periphery of the protrusion (or the opening of the recess) is in the aforementioned range, for example.

When the protrusions **110d** are shaped so as to protrude above the upper surface **110a** of the lightguide plate **110D,** total reflection inside the lightguide plate **110D** is suppressed so that the effect of increasing the light extracted from the upper surface **110a** can be achieved. Thus, the protrusions **110d** may have various shapes including hemispherical, conical, pyramidal, and truncated pyramidal shapes.

In the example shown in FIG. **16,** the plurality of protrusions **110d** are two-dimensionally arranged in the first region **111A** such that the centers of the protrusions **110d** are located on the lattice points of a triangular lattice. As a matter of course, the arrangement of the plurality of protrusions **110d** is not limited to this example, and an arbitrary arrangement can be employed according to desired optical characteristics. For example, the plurality of protrusions **110d** may be two-dimensionally arranged in the first region **111A** such that the centers of the protrusions **110d** are located on the lattice points of a square lattice.

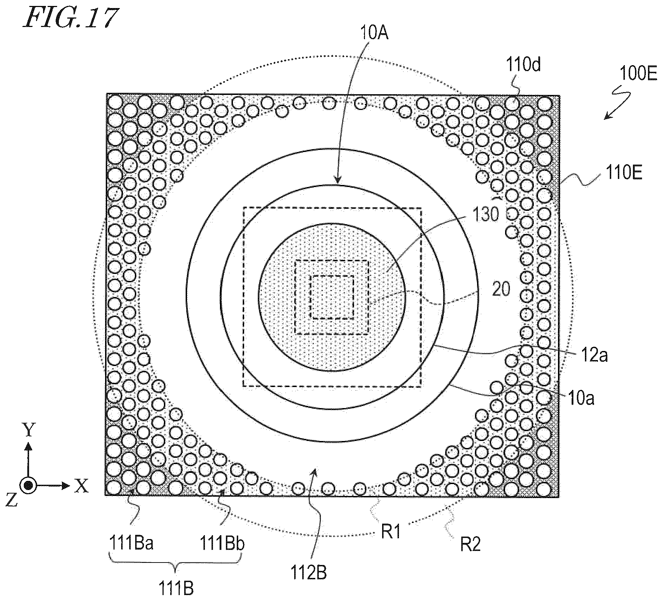

FIG. **17** shows another example of a lightguide plate which has a plurality cf protrusions at the upper surface. The light emitting module **100E** shown in FIG. **17** includes a lightguide plate **110E**. The lightguide plate **110E** has, at its upper surface **110a,** a first region **111B** and a second region **112B** located more internal than the first region **111B**. The second region **112B** is an annular region of the upper surface **110a** of the lightguide plate **110E** surrounding the first hole **10A**. The first region **111B** is a region outside the second region **112B** and surrounds the second region **112B.**

In the example shown in FIG. **17,** the first region **111B** is a part of the upper surface **110a** which is outside the imaginary circle **R1**, and a plurality of protrusions **110d** are provided at its surface. Likewise as in the example which has been described with reference to FIG. **16,** the diameter of the circular shape of protrusions **110d** located in part of the first region **111B** outside the above-described imaginary circle **R2** is greater than the diameter of the circular shape of protrusions **110d** located in another part of the first region **111B** inside the imaginary circle **R2**. Part of the first region **111B** outside the imaginary circle **R2** may be referred to as "outer region", and another part of the first region **111B** which is closer to the light emitting element **120** than the outer region, in other words, a region between the imaginary circles **R1** and **R2,** may be referred to as "inner region". In FIG. **17,** the inner region **111Bb** is represented as the shaded area, and the outer region **111Ba** is represented as the darker-shaded area, for ease of understanding.

Meanwhile, the second region **112B** is another part of the upper surface **110a** lying between the imaginary circle **R1** and the opening **10a** of the first hole **10A,** and no protrusions **110d** are provided at its surface. Therefore, in this example, the surface of the second region **112B** is a flat surface. As illustrated in FIG. **17,** the plurality of protrusions **110d** do not need to be provided across the entirety of the first region **111B** but may be provided in at least part of the first region **111B.** When for example a plurality of protrusions **110d** are provided in a region of the lightguide plate **110E** which is relatively distant from the light emitting element **120,** light extracted from the region which is relatively distant from the light emitting element **120,** i.e., light extracted from the first region **111B,** increases as compared with the second region **112B.** As a result, the luminance of the first region **111B** that is more distant from the light emitting element **120** increases, and occurrence of luminance unevenness can be more effectively reduced.

Thus, in the examples shown in FIG. **15** to FIG. **17,** in the upper surface **110a** of the lightguide plate, the proportion of the plurality of protrusions **110d** per unit area increases concentrically in an outward direction from the light emitting element **120.** Herein, the term "concentrically" used in this specification means having a common center but does not intend to mean that the shape of a plurality of figures which have a common center is limited to a perfect circle. The above-described imaginary circle **R1** and/or circle **R2** are not limited to perfect circles but can be ellipses or the like. For example, the upper surface **110a** of the lightguide plate **110E** is rectangular, the imaginary circle **R1** and the imaginary circle **R2** may be elliptical. In this case, the centers of these ellipses refer to the intersection of the major axis and the minor axis.

As previously described, the protrusions **110d** can achieve the effect of increasing light extracted from the upper surface **110a** so long as the protrusions **110d** are shaped so as to protrude above the upper surface **110a** of the lightguide plate. Therefore, such a configuration can be employed that the proportion of the plurality of protrusions **110d** per unit area is constant in the first region.

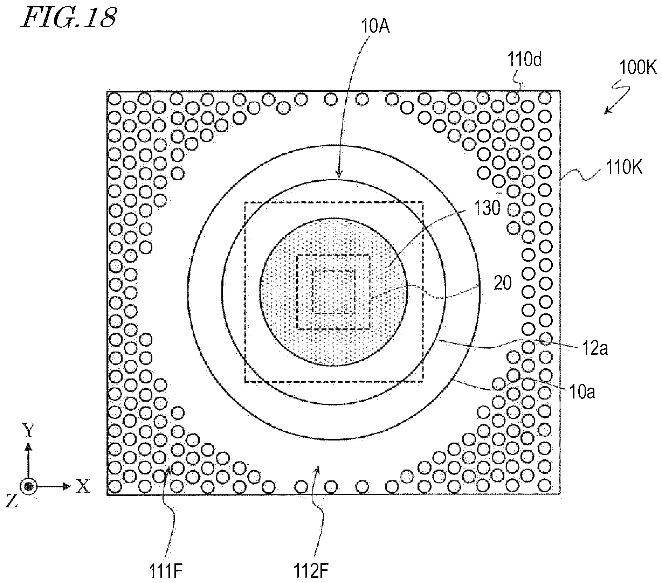

FIG. **18** shows still another example of a lightguide plate which has a plurality of protrusions at the upper surface. The light emitting module **100K** shown in FIG. **18** includes a lightguide plate **110K.** The lightguide plate **110K** has, at its upper surface **110a,** a first region **111F** and a second region **112F** located more internal than the first region **111F.** In this example, a plurality of protrusions **110d** are selectively provided in the first region **111F** at a constant pitch so as to have a constant size. If the proportion of the plurality of protrusions **110d** per unit area is constant, such a configuration is possible that either or both of the size and the arrangement pitch of the plurality of protrusions **110d** are not constant. According to the configuration illustrated in FIG. **18,** within the upper surface **110a** of the lightguide plate, the luminance of the first region **111F** in which the plurality of protrusions **110d** are provided can be relatively improved. The second region **112F** may be omitted such that the plurality of protrusions **110d** are provided across the entirety of the upper surface **110a.**

The shape of the protrusions provided in the first region is not limited to these examples. For example, the protrusions may be in the form of an annular convex ring. In this case, for example, by increasing the width of a plurality of convex rings as the distance from the light emitting element **120** increases, the proportion of the plurality of protrusions per unit area as viewed in plan can be increased concentrically in an outward direction from the light emitting element **120.** Therefore, likewise as in a case where a plurality of protrusions in the form of dots are provided in the first region, the luminance at a position in the first region which is distant from the light emitting element **120** can be improved, and the effect of suppressing luminance unevenness can be achieved.

A plurality of protrusions each having an annular shape and a plurality of protrusions each having the shape of a dot may be provided together at the upper surface **110a.** When the protrusions in the shape of dots are provided in addition to the annular protrusions, it is possible to suppress occurrence of an annular brightness/darkness pattern as compared with a case only the annular protrusions are provided.

Alternatively, a plurality of recesses may be provided in place of the plurality of protrusions. In this case, the plurality of recesses have such shapes that, for example, the opening of the recesses increases as the distance from the light emitting element **120** increases.

The plurality of recesses can be, for example, a plurality of dots. Herein, the term "dot" used in this specification generally refers to a figure which is round in a plan view, such as circle and ellipse. The term "dot" used in this specification is interpreted as including both a feature protruding above the upper surface **110a** of the lightguide plate and a feature recessed below the upper surface **110a.** Alternatively, the plurality of recesses may have the shape of an annular groove in the first region of the upper surface **110a.** By increasing the width of the ringshaped groove as the distance from the light emitting element **120** increases, the proportion of the plurality of recesses per unit area as viewed in plan may be increased concentrically in an outward direction from the light emitting element **120.** Alternatively, the interval of the plurality of recesses each having an annular shape may be gradually decreased.

Alternatively, a plurality of protrusions and a plurality of recesses may be provided together in the first region. The first region of the upper surface **110a** of the lightguide plate can have a combination of two or more types of features selected from a plurality of protrusions each having the shape of a dot, a plurality of recesses each having the shape of a dot, a plurality of protrusions each having an annular shape, and a plurality of recesses each having an annular shape.

**EP 3 705 773 B1**

[EXAMPLES]

A plurality of samples of which the first holes had different configurations were produced and examined the distribution of the luminance achieved when a light emitting element was lit up. A two-stage slope was provided in the lateral surface of the first hole, and the reflective resin layer **130** was selectively formed inside the first portion which was a part of the first hole closer to the lower surface of the lightguide plate. The effect of suppressing luminance unevenness which was achieved by this configuration was investigated.

(Example)

As a sample of Example, a surface-emission light source was produced which included an array of light emitting modules in 4 rows and 4 columns, each having the same configuration as the light emitting module **100B** shown in FIG. **11.** Herein, the entirety of the first portion **11B** of the first hole **10B** was filled with a silicone resin containing titanium oxide particles.

(Comparative Example)

As a sample of Comparative Example, a surface-emission light source was produced of which the shape of the first hole of each light emitting module was conical such that the lateral surface had a monotonous slope, and the entirety of the first hole was filled with a silicone resin containing titanium oxide particles.

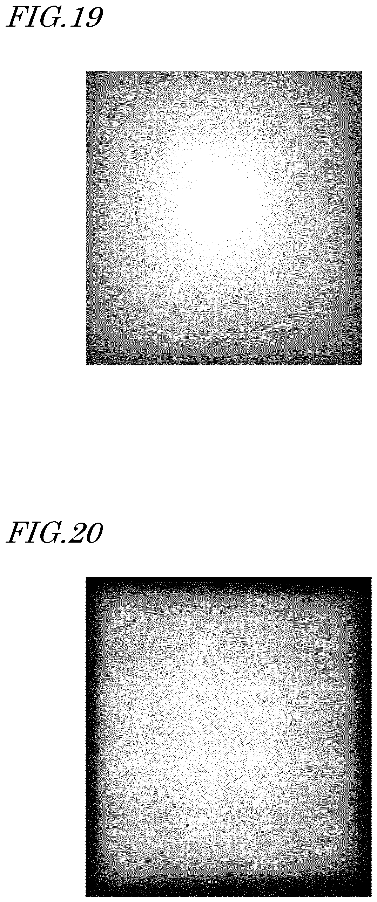

FIG. **19** shows the external appearance of the sample of Example as viewed from the upper surface side of the lightguide plate. In FIG. **19,** the external appearance is shown in a circumstance where the light emitting elements were lit up with a diffuser sheet and first and second prism sheets were being placed on the upper surface side of the lightguide plate. FIG. **20** shows the external appearance of the sample of Comparative Example as viewed from the upper surface side of the lightguide plate as does FIG. **19.** In FIG. **20,** the external appearance is shown in a circumstance where the light emitting elements were lit up with a diffuser sheet and first and second prism sheets were being placed on the upper surface side of the lightguide plate. Herein, the first prism sheet and the second prism sheet were provided on the upper surface side of the lightguide plate such that the knife edges of the prisms of the first prism sheet perpendicularly intersected the knife edges of the prisms of the second prism sheet.
As seen from the comparison between FIG. **19** and FIG. **20,** in the sample of Example, the luminance unevenness as viewed from the upper surface side of the lightguide plate is more suppressed. We evaluated the uniformity in luminance through the following procedure. From 16 light emitting modules arrayed in 4 rows and 4 columns, the part of 2 rows and 2 columns at the center was taken out and divided into a plurality of regions with a mesh of an arbitrary size. In each of the regions, the luminance was measured. The maximum and the minimum were extracted from luminance values measured in respective regions, and values resulting from the calculation of the following formula, which are referred to as "luminance uniformity (%)" of the samples, were compared.

```
((minimum luminance)/(maximum luminance))*100 ("*" means

multiplication)
```

The luminance uniformity of the sample of Comparative Example was 78%. The luminance uniformity of the sample of Example was 92%. That is, in the sample of Example, the difference between the maximum luminance and the minimum luminance in the part of 2 rows and 2 columns at the center was smaller. Thus, it was ascertained that, by shaping the lateral surface of the first hole so as to have a two-stage slope and selectively forming a light-reflective resin layer in the first portion, the luminance unevenness across the upper surface of the lightguide plate can be more effectively suppressed as compared with a case where a light-reflective resin layer is formed over the entirety of the conical first hole.
The embodiments of the present disclosure are useful in various types of light sources for lighting, on-vehicle light sources, display light sources, etc. Particularly, the embodiments of the present disclosure are advantageously applicable to backlight units for liquid crystal display devices. The light emitting module or surface-emission light source according to the embodiments of the present disclosure may suitably be used in backlights for display devices of mobile devices, for which there are strong demands for reducing the thickness, surface-emitting devices that are capable of local dimming, etc.

**EP 3 705 773 B1**

**Claims**

1. A light emitting module (100) comprising:

    a lightguide plate (110A) having an upper surface (110a) and a lower surface (110b) that is opposite to the upper surface, the upper surface including a first hole (10A);
    a light emitting element (120) on a lower surface side of the lightguide plate, the light emitting element facing the first hole; and
    a reflective resin layer (130),
    wherein the first hole includes a first portion (11A) and a second portion (12A),
    the first portion includes a first lateral surface (11c) sloping with respect to the upper surface,
    the second portion has a second lateral surface (12c) sloping with respect to the upper surface, the second lateral surface being present between an opening (12a) in the upper surface and the first lateral surface of the first portion
    an inclination of the first lateral surface with respect to the upper surface is smaller than an inclination of the second lateral surface with respect to the upper surface, and
    the reflective resin layer (130) is located in the first portion of the first hole.

2. The light emitting module of claim 1, wherein a refractive index inside the second portion of the first hole is lower than a refractive index of the reflective resin layer.

3. The light emitting module of claim 1 or 2, wherein the first portion (11B) of the first hole (10B) further has a bottom surface (11b) connecting to the first lateral surface.

4. The light emitting module of any of claims 1 to 3, wherein a shape of the second lateral surface in a cross section perpendicular to the upper surface is a curved shape.

5. The light emitting module of any of claims 1 to 4, wherein

    the lower surface of the lightguide plate has a second hole (20) at a position opposite to the first hole, and
    the light emitting element is located inside the second hole in a plan view.

6. The light emitting module of claim 5, further comprising a wavelength conversion member (150) located inside the second hole between the light emitting element and the lightguide plate.

7. The light emitting module of any of claims 1 to 4, wherein

    the light emitting element is located inside the first hole in a plan view, and
    the light emitting module further includes a wavelength conversion member (150) located between the light emitting element and the lightguide plate.

8. The light emitting module of any of claims 1 to 4, further comprising a wavelength conversion sheet (350) located on or above the upper surface of the lightguide plate.

9. The light emitting module of any of claims 1 to 8, wherein
    the light emitting module further includes a light-reflective member (140) which covers at least part of the lower surface of the lightguide plate.

10. The light emitting module of claim 9, wherein

    the light emitting element includes an electrode (124) on a side opposite to the lightguide plate, and
    the light emitting module further comprises an interconnect layer (180) located on a lower surface side of the light-reflective member, the interconnect layer being electrically coupled with the electrode.

11. The light emitting module of claim 9 or 10, wherein the light-reflective member includes a wall portion (140w) rising from the lower surface side of the lightguide plate toward an upper surface side of the lightguide plate, the wall portion having a slope surface (140s) which surrounds the light emitting element.

12. A surface-emission light source (200) comprising a plurality of the light emitting modules of claims 1 to 11, wherein the plurality of the light emitting modules are two-dimensionally arrayed.

**Patentansprüche**

1. Lichtemittierendes Modul (100), umfassend:

    eine lichtführende Platte (110A) mit einer oberen Oberfläche (110a) und einer unteren Oberfläche (110b), die entgegengesetzt zu der oberen Oberfläche ist, wobei die obere Oberfläche ein erstes Loch (10A) enthält;
    ein lichtemittierendes Element (120) an einer unteren Oberflächenseite der lichtführenden Platte, wobei das lichtemittierende Element dem ersten Loch zugewandt ist; und
    eine reflektierende Harzschicht (130),
    wobei das erste Loch einen ersten Bereich (11A) und einen zweiten Bereich (12A) umfasst,
    wobei der erste Bereich eine erste laterale Oberfläche (11c) umfasst, die bezüglich der oberen Oberfläche geneigt ist,
    wobei der zweite Bereich eine zweite laterale Oberfläche (12c) hat, die bezüglich der oberen Oberfläche geneigt ist, wobei die zweite laterale Oberfläche zwischen einer Öffnung (12a) in der oberen Oberfläche und der ersten lateralen Oberfläche des ersten Bereichs vorhanden ist,
    wobei eine Neigung der ersten lateralen Oberfläche bezüglich der oberen Oberfläche kleiner ist als eine Neigung der zweiten lateralen Oberfläche bezüglich der oberen Oberfläche, und
    wobei die reflektierende Harzschicht (130) in dem ersten Bereich des ersten Lochs lokalisiert ist.

2. Lichtemittierendes Modul nach Anspruch 1, wobei ein Brechungsindex innerhalb des zweiten Bereichs des ersten Lochs kleiner ist als ein Brechungsindex der reflektierenden Harzschicht.

3. Lichtemittierendes Modul nach Anspruch 1 oder 2, wobei der erste Bereich (11B) des ersten Lochs (10B) ferner eine Bodenoberfläche (11b) zur Verbindung mit der ersten lateralen Oberfläche hat.

4. Lichtemittierendes Modul nach einem der Ansprüche 1 bis 3, wobei eine Gestalt der zweiten lateralen Oberfläche in einem Querschnitt orthogonal zu der oberen Oberfläche eine gekrümmte Gestalt ist.

5. Lichtemittierendes Modul nach einem der Ansprüche 1 bis 4, wobei

    die untere Oberfläche der lichtführenden Platte ein zweites Loch (20) an einer Position entgegengesetzt zu dem ersten Loch hat, und
    das lichtemittierende Element in einer Draufsicht innerhalb des zweiten Lochs lokalisiert ist.

6. Lichtemittierendes Modul nach Anspruch 5, ferner umfassend ein Wellenlängenumwandlungselement (150), das innerhalb des zweiten Lochs zwischen dem lichtemittierenden Element und der lichtführenden Platte lokalisiert ist.

7. Lichtemittierendes Modul nach einem der Ansprüche 1 bis 4, wobei

    das lichtemittierende Element in einer Draufsicht innerhalb des ersten Lochs lokalisiert ist, und
    das lichtemittierende Modul ferner ein Wellenlängenumwandlungselement (150) umfasst, das zwischen dem lichtemittierenden Element und der lichtführenden Platte lokalisiert ist.

8. Lichtemittierendes Modul nach einem der Ansprüche 1 bis 4, ferner umfassend eine Wellenlängenumwandlungsschicht (350), die auf oder über der oberen Oberfläche der lichtführenden Platte lokalisiert ist.

9. Lichtemittierendes Modul nach einem der Ansprüche 1 bis 8, wobei das lichtemittierende Modul ferner ein lichtreflektierendes Element (140) umfasst, das wenigstens einen Teil der unteren Oberfläche der lichtführenden Platte bedeckt.

10. Lichtemittierendes Modul nach Anspruch 9, wobei

    das lichtemittierende Element eine Elektrode (124) auf einer Seite entgegengesetzt zu der lichtführenden Platte umfasst, und

das lichtemittierende Modul ferner eine Zwischenverbindungsschicht (180) umfasst, die an einer unteren Oberflächenseite des lichtreflektierenden Elements lokalisiert ist, wobei die Zwischenverbindungsschicht elektrisch mit der Elektrode gekoppelt ist.

**11.** Lichtemittierendes Modul nach Anspruch 9 oder 10, wobei das lichtreflektierende Element einen Wandbereich (140w) umfasst, der von der unteren Oberflächenseite der lichtführenden Platte in Richtung einer oberen Oberflächenseite der lichtführenden Platte ansteigt, wobei der Wandbereich eine geneigte Oberfläche (140s) hat, die das lichtemittierende Element umgibt.

**12.** Oberflächenemissionslichtquelle (200), umfassend eine Mehrzahl der lichtemittierenden Module nach einem der Ansprüche 1 bis 11,
wobei die Mehrzahl der lichtemittierenden Module zweidimensional angeordnet sind.

## Revendications

**1.** Module émetteur de lumière (100) comprenant :

une plaque de guide de lumière (110A) ayant une surface supérieure (110a) et une surface inférieure (110b) qui est à l'opposé de la surface supérieure, la surface supérieure comportant un premier trou (10A) ;
un élément émetteur de lumière (120) sur un côté de surface inférieure de la plaque de guide de lumière, l'élément émetteur de lumière faisant face au premier trou ; et
une couche de résine réfléchissante (130),
dans lequel le premier trou comporte une première portion (11A) et une deuxième portion (12A),
la première portion comporte une première surface latérale (11c) inclinée par rapport à la surface supérieure,
la deuxième portion a une deuxième surface latérale (12c) inclinée par rapport à la surface supérieure, la deuxième surface latérale étant présente entre une ouverture (12a) dans la surface supérieure et la première surface latérale de la première portion,
une inclinaison de la première surface latérale par rapport à la surface supérieure est inférieure à une inclinaison de la deuxième surface latérale par rapport à la surface supérieure, et
la couche de résine réfléchissante (130) est située dans la première portion du premier trou.

**2.** Module émetteur de lumière selon la revendication 1, dans lequel un indice de réfraction à l'intérieur de la deuxième portion du premier trou est inférieur à un indice de réfraction de la couche de résine réfléchissante.

**3.** Module émetteur de lumière selon la revendication 1 ou 2, dans lequel la première portion (11B) du premier trou (10B) a en outre une surface de fond (11b) reliant la première surface latérale.

**4.** Module émetteur de lumière selon l'une quelconque des revendications 1 à 3, dans lequel une forme de la deuxième surface latérale dans une coupe transversale perpendiculaire à la surface supérieure est une forme incurvée.

**5.** Module émetteur de lumière selon l'une quelconque des revendications 1 à 4, dans lequel

la surface inférieure de la plaque de guide de lumière a un deuxième trou (20) à une position à l'opposé du premier trou, et
l'élément émetteur de lumière est situé à l'intérieur du deuxième trou dans une vue en plan.

**6.** Module émetteur de lumière selon la revendication 5, comprenant en outre un organe de conversion de longueur d'onde (150) situé à l'intérieur du deuxième trou entre l'élément émetteur de lumière et la plaque de guide de lumière.

**7.** Module émetteur de lumière selon l'une quelconque des revendications 1 à 4, dans lequel

l'élément émetteur de lumière est situé à l'intérieur du premier trou dans une vue en plan, et
le module émetteur de lumière comporte en outre un organe de conversion de longueur d'onde (150) situé entre l'élément émetteur de lumière et la plaque de guide de lumière.

**8.** Module émetteur de lumière selon l'une quelconque des revendications 1 à 4, comprenant en outre une feuille de conversion de longueur d'onde (350) située sur ou au-dessus de la surface supérieure de la plaque de guide de lumière.

9. Module émetteur de lumière selon l'une quelconque des revendications 1 à 8, dans lequel
le module émetteur de lumière comporte en outre un organe réfléchissant la lumière (140) qui recouvre au moins une partie de la surface inférieure de la plaque de guide de lumière.

10. Module émetteur de lumière selon la revendication 9, dans lequel

l'élément émetteur de lumière comporte une électrode (124) sur un côté à l'opposé de la plaque de guide de lumière, et
le module émetteur de lumière comprend en outre une couche d'interconnexion (180) située sur un côté de surface inférieure de l'organe réfléchissant la lumière, la couche d'interconnexion étant couplée électriquement à l'électrode.

11. Module émetteur de lumière selon la revendication 9 ou 10, dans lequel l'organe réfléchissant la lumière comporte une portion de paroi (140w) s'élevant du côté de surface inférieure de la plaque de guide de lumière vers un côté de surface supérieure de la plaque de guide de lumière, la portion de paroi ayant une surface inclinée (140s) qui entoure l'élément émetteur de lumière.

12. Source de lumière à émission de surface (200) comprenant une pluralité des modules émetteurs de lumière selon les revendications 1 à 11,
dans laquelle la pluralité des modules émetteurs de lumière sont en réseau bidimensionnel.

*FIG.1*

*FIG.2*

*FIG.3*

*FIG.4*

*FIG.5*

*FIG.6*

FIG.7

EP 3 705 773 B1

FIG.8

*FIG.9*

*FIG.10*

*FIG.11*

*FIG.12*

*FIG.13*

*FIG.14*

**FIG.15**

**FIG.16**

FIG.17

*FIG.18*

FIG.19

FIG.20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009150940 A
- JP 2009063684 A
- JP 3688832 B
- KR 20100057321 A
- US 2012069575 A1
- TW 201116900 A
- US 2004042194 A1
- JP 2007329114 A
- US 2007121340 A1